# EUROPEAN PATENT APPLICATION

(11) **EP 4 206 287 A1**
(43) Date of publication of application: **05.07.2023**
(21) Application number: 21869306.7
(22) Date of filing: 10.09.2021
(51) Int. Cl.: C08L 101/00, C08K 5/3415, C08L 101/08, G02B 5/22, G03F 7/004, H01L 27/146

(54) **RESIN COMPOSITION**

(30) Priority: 17.09.2020 JP 2020156325
(71) Applicant: SUMITOMO CHEMICAL COMPANY, LIMITED, Tokyo 103-6020 (JP)
(72) Inventor: AKASAKA, Tetsuo, Osaka-shi, Osaka 554-8558 (JP); MATSUYAMA, Ayaka, Osaka-shi, Osaka 554-8558 (JP); AOKI, Takuma, Osaka-shi, Osaka 554-8558 (JP); KAWANISHI, Yutaka, Osaka-shi, Osaka 554-8558 (JP)
(74) Representative: Vossius & Partner Patentanwälte Rechtsanwälte mbB
(86) International application number: PCT/JP2021/033351
(87) International publication number: WO 2022/059619

(57) **Abstract**

An objective of the present invention is to provide a resin composition capable of improving at least either one of heat resistance and visible light transmission. A resin composition according to an aspect of the present invention contains a coloring agent and a resin, and the coloring agent contains a compound represented by a formula (I), a formula (II), a formula (III) or a formula (IV).

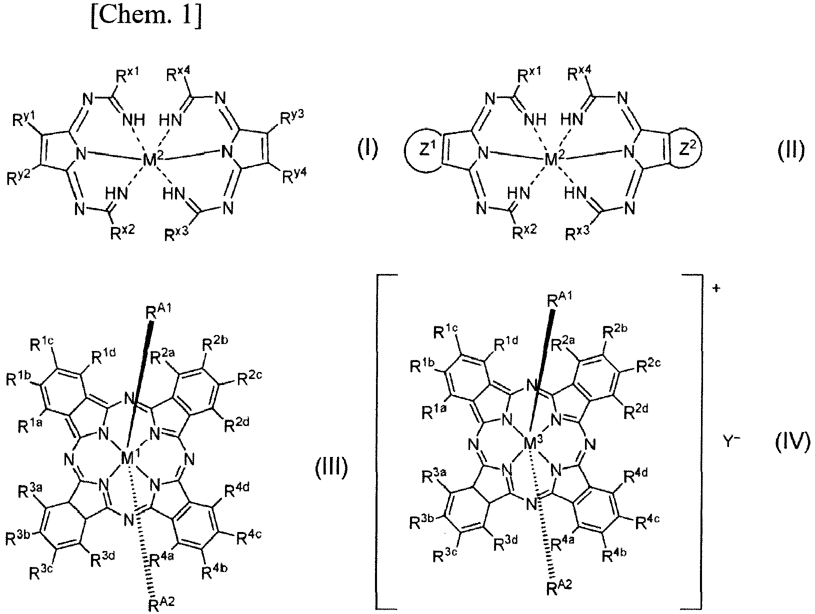

## Description

### Technical Field

The present invention relates to a resin composition, an optical filter and a solid state image sensor.

### Background Art

Optical filters that are used in display devices such as liquid crystal display devices, electroluminescence display devices and plasma displays, and solid state image sensors such as CCD and CMOS sensors are manufactured from curable resin compositions. As such curable resin compositions, a composition containing a phthalocyanine compound, which is a coloring agent, is known (Patent Literature 1). Patent Literature 1 describes that the above-described composition absorbs near-infrared rays and is capable of forming fine patterns.

### Citation List

### Patent Literature

Patent Literature 1: Japanese Unexamined Patent Application Publication No. 2010-160380

### Summary of Invention

### Technical Problem

However, the heat resistance of the curable resin composition of Patent Literature 1 was not sufficient, and, when such a curable resin composition was heated at a high temperature (for example, 120°C or higher) for a predetermined time, there were cases where the absorption rate of near-infrared rays (700 nm to 3 µm) decreases. In addition, the visible light transmittance of such a resin composition was also not sufficiently high. Therefore, an objective of the present invention is to provide a resin composition capable of improving at least either one of heat resistance and visible light transmission, and preferably both of heat resistance and visible light transmission.

### Solution to Problem

A resin composition according to an aspect of the present invention contains a coloring agent and a resin, and the coloring agent contains a compound represented by a formula (I), a formula (II), a formula (III) or a formula (IV).

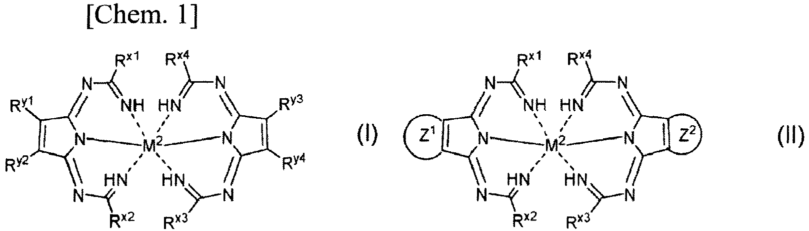

[In the formula (I) and the formula (II),
R^{x1} to R^{x4} each independently represent a chain hydrocarbon group having 1 to 20 carbon atoms, an aryl group having 6 to 20 carbon atoms or a heteroaryl group having 2 to 20 carbon atoms,
-CH₂- contained in the chain hydrocarbon group is optionally substituted with -O-,
a hydrogen atom contained in the chain hydrocarbon group is optionally substituted with a halogen atom,
hydrogen atoms contained in the aryl group and the heteroaryl group are each independently optionally substituted with a halogen atom, -OR¹, -SR¹ or -NR²R³,
R¹ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR²- or -N⁺(R²R³)X⁻-, and hydrogen atoms contained in the aryl group and the heteroaryl group are each independently optionally substituted with a halogen atom or a straight chain or branched chain alkoxy group having 1 to 20 carbon atoms,
R² and R³ each independently represent a hydrogen atom or a chain hydrocarbon group having 1 to 10 carbon atoms, wherein -CH₂-contained in the hydrocarbon group is optionally substituted with -O-, or
R² and R³ bond to each other to form a ring,
X represents a halogen atom, PF₆, ClO₄ or BF₄,
R^{y1} to R^{y4} in the formula (I) each independently represent a chain hydrocarbon group having 1 to 20 carbon atoms, an aryl group having 6 to 20 carbon atoms or a heteroaryl group having 2 to 20 carbon atoms,
-CH₂- contained in the chain hydrocarbon group is optionally substituted with -O-,
a hydrogen atom contained in the chain hydrocarbon group is optionally substituted with a halogen atom,
hydrogen atoms contained in the aryl group and the heteroaryl group are each independently optionally substituted with a halogen atom, -OR¹, -SR¹ or -NR²R³,
a ring Z¹ and a ring Z² in the formula (II) each independently represent an aromatic hydrocarbon ring having 6 to 20 carbon atoms or a heteroaromatic ring having 2 to 20 carbon atoms,
hydrogen atoms contained in the aromatic hydrocarbon ring and the heteroaromatic ring are optionally substituted with a halogen atom, a chain hydrocarbon group having 1 to 20 carbon atoms, -OR¹, -SR¹ or -NR²R³,
when a plurality of R¹s, R²s or R³s is present, these may be the same as or different from each other, and
M² represents a divalent metal atom.]

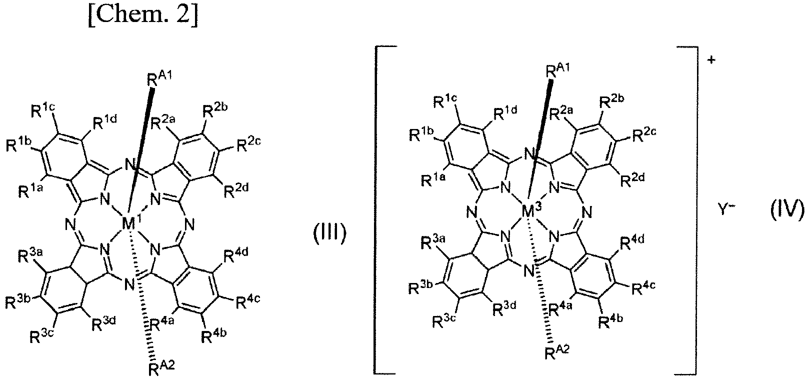

[In the formula (III) and the formula (IV),
R^{1a} to R^{1d}, R^{2a} to R^{2d}, R^{3a} to R^{3d} and R^{4a} to R^{4d} each independently represent a hydrogen atom, a halogen atom, a chain hydrocarbon group having 1 to 20 carbon atoms, -OR¹, -SR¹ or -NR²R³, wherein at least one of R^{1a} to R^{1d}, R^{2a} to R^{2d}, R^{3a} to R^{3d} and R^{4a} to R^{4d} represents -SR¹,
R¹ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR²- or -N⁺(R²R³)X⁻-, and hydrogen atoms contained in the aryl group and the heteroaryl group are each independently optionally substituted with a halogen atom or a straight chain or branched chain alkoxy group having 1 to 20 carbon atoms,
R² and R³ each independently represent a hydrogen atom or a chain hydrocarbon group having 1 to 10 carbon atoms, wherein -CH₂-contained in the hydrocarbon group is optionally substituted with -O-, or
R² and R³ bond to each other to form a ring,
X represents a halogen atom, PF₆, ClO₄ or BF₄,
R^{A1} and R^{A2} each independently represent -OR⁴,
R⁴ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR⁵- or -N⁺(R⁵R⁶)X⁻-,
R⁵ and R⁶ each independently represent a hydrogen atom or a chain hydrocarbon group having 1 to 10 carbon atoms,
when a plurality of R¹s, R²s, R³s, R⁵s or R⁶s is present, these may be the same as or different from each other,
M¹ in the formula (III) represents a tetravalent metal atom or a non-metal atom,
M³ in the formula (IV) represents a pentavalent metal atom or a non-metal atom, and
Y⁻ in the formula (IV) represents a monovalent anion.]

The resin composition may further contain a polymerizable compound and a polymerization initiator.

The resin may be a copolymer containing a structural unit derived from at least one selected from the group consisting of an unsaturated carboxylic acid and an unsaturated carboxylic acid anhydride, and a structural unit derived from a monomer having a cyclic ether structure having 2 to 4 carbon atoms and an ethylenic unsaturated bond

In the above formulae (I) to (IV),
R^{x1} to R^{x4} may each independently represent an aryl group having 6 to 20 carbon atoms,
R^{y1} to R^{y4} may each independently represent an aryl group having 6 to 20 carbon atoms,
the ring Z¹ and the ring Z² may each independently represent an aromatic hydrocarbon ring having 6 to 20 carbon atoms,
M² may represent Ru, Fe, Cu, Zn, Co, Ni or Pd,
R^{1a} to R^{1d}, R^{2a} to R^{2d}, R^{3a} to R^{3d} and R^{4a} to R^{4d} may each independently represent a hydrogen atom or -SR¹,
R⁴ may represent a hydrogen atom or a chain hydrocarbon group having 1 to 10 carbon atoms, wherein -CH₂- contained in the chain hydrocarbon group is optionally substituted with -O-, -NR⁵- or -N+(R⁵R⁶)X⁻-,
M¹ may represent Si, and
M³ may represent P.

Here,
R^{x1} to R^{x4} may each independently represent an aryl group having 6 to 10 carbon atoms,
R^{y1} to R^{y4} may each independently represent an aryl group having 6 to 10 carbon atoms,
the ring Z¹ and the ring Z² may each independently represent an aromatic hydrocarbon ring having 6 to 10 carbon atoms,
M² may represent Ru,
R¹ may represent an aryl group having 6 to 10 carbon atoms, and
R⁴ may represents a hydrogen atom or a chain hydrocarbon group having 1 to 10 carbon atoms, wherein -CH₂- contained in the chain hydrocarbon group is optionally substituted with -O- or -N⁺(R ⁵R⁶)X⁻-.

In addition, the coloring agent may contain a compound represented by the formula (I) or the formula (II).

The coloring agent may contain a compound represented by any of the following formulae.

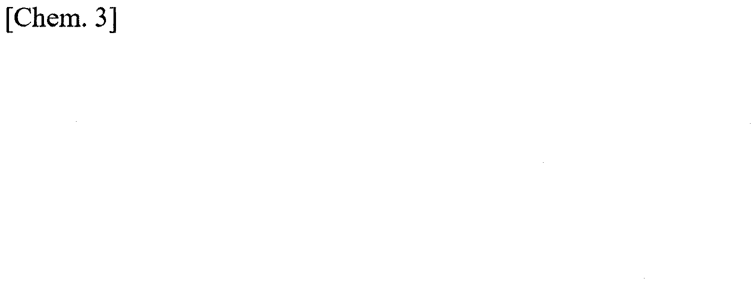

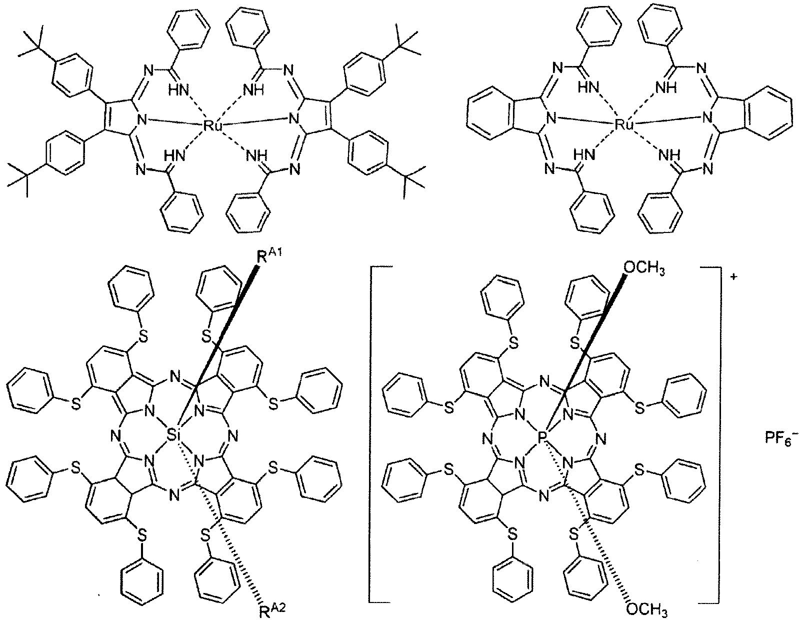

[In the formulae, R^{A1} and R^{A2} represent -OCH₂CH₂OCH₂CH₂OCH₂CH₃, -OCH₂CH₂N⁺(CH₃)₃ I⁻ or a hydroxyl group.]

An optical filter according to an aspect of the present invention contains a cured product of the resin composition.

A solid state image sensor according to an aspect of the present invention includes the optical filter.

### Advantageous Effects of Invention

The resin composition according to an aspect of the present invention is excellent in at least either one of heat resistance and visible light transmission. Therefore, according to the present invention, it is possible to obtain an optical filter in which at least either one of heat resistance and visible light transmission is improved. A cured product of the resin composition according to an aspect of the present invention absorbs a specific wavelength in the near-infrared region while sufficiently transmitting visible light and thus can be used as a near-infrared cut filter. In addition, the cured product of the resin composition according to an aspect of the present invention can be used as a near-infrared transmission filter that transmits a specific wavelength in the near-infrared region.

### Brief Description of Drawings

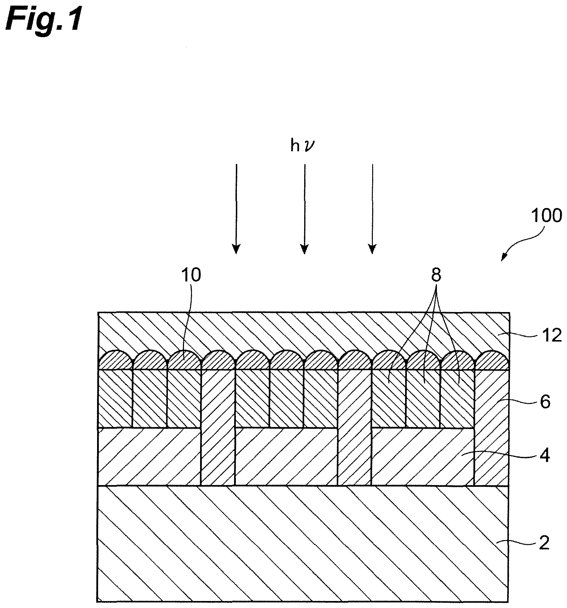

FIG. 1 is a schematic view showing an example of a solid state image sensor.

### Description of Embodiments

In the present specification, Me, Ph, Ts and Pc represent a methyl group, a phenyl group, a tosyl group and phthalocyanine, respectively.

### <Resin Composition>

A resin composition according to an aspect of the present invention contains a coloring agent and a resin (hereinafter referred to as the coloring agent (A) and the resin (B), respectively, in some cases). The resin composition may further contain one or more of a polymerizable compound, a polymerization initiator, a solvent and a leveling agent (hereinafter referred to as the polymerizable compound (C), the polymerization initiator (D), the solvent (E) and the leveling agent (F), respectively, in some cases). In the present specification, unless particularly otherwise described, a compound that is exemplified as each component may be used alone or a plurality of compounds may be used in combination. The resin composition is preferably excellent in both of heat resistance and visible light transmission, and more preferably also excellent in light resistance.

### <Coloring Agent (A)>

In the present specification, a coloring agent means a substance that absorbs a specific wavelength, and, for example, a visible light absorber, an infrared absorber, a near-infrared absorber and an ultraviolet absorber are encompassed in the scope of the coloring agent. The coloring agent (A) contains a compound represented by a formula (I), a formula (II), a formula (III) or a formula (IV) (hereinafter referred to as the coloring agent (A1) in some cases).

The compound represented by the formula (I) and the compound represented by the formula (II) are as follows.

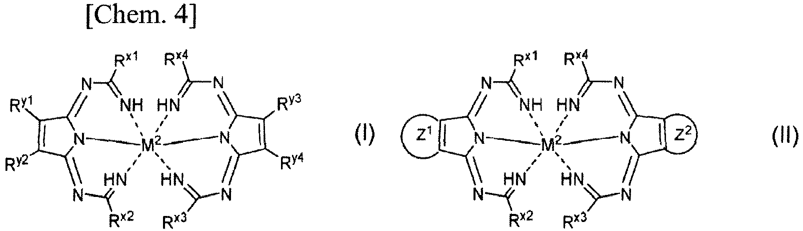

In the formula (I) and the formula (II), R^{x1} to R^{x4} each independently represent a chain hydrocarbon group having 1 to 20 carbon atoms, an aryl group having 6 to 20 carbon atoms or a heteroaryl group having 2 to 20 carbon atoms. R^{x1} to R^{x4} preferably represent aryl groups having 6 to 20 carbon atoms.

In the chain hydrocarbon group having 1 to 20 carbon atoms represented by R^{x1} to R^{x4}, one or more -CH₂-s may be substituted with -O-, and one or more hydrogen atoms may be substituted with a halogen atom. The chain hydrocarbon group having 1 to 20 carbon atoms represented by R^{x1} to R^{x4} may be, for example, a methyl group, an ethyl group, a n-propyl group, an isopropyl group, a n-butyl group, an isobutyl group, a s-butyl group, a t-butyl group, a n-pentyl group, a n-hexyl group, a n-heptyl group, a 2-ethylhexyl group, a n-octyl group, a 2-ethylbutyl group, a 3,3-dimethylbutyl group, a 1,1,3,3-tetramethylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group or 1-butylhexyl group.

The aryl group having 6 to 20 carbon atoms represented by R^{x1} to R^{x4} is an aryl group preferably having 6 to 18 carbon atoms, more preferably having 6 to 12 carbon atoms and still more preferably having 6 to 10 carbon atoms. In the aryl group, one or more hydrogen atoms may be substituted with a halogen atom, -OR¹, -SR¹ or -NR²R³.

R' represents a hydrogen atom; a chain hydrocarbon group having 1 to 10 carbon atoms in which one or more -CH₂-s may be substituted with -O-, -NR²- or -N⁺(R²R³)X⁻-; an aryl group having 6 to 20 carbon atoms in which one or more hydrogen atoms may be substituted with a halogen atom or a straight chain or branched chain alkoxy group having 1 to 20 carbon atoms; or a heteroaryl group having 2 to 20 carbon atoms in which one or more hydrogen atoms may be substituted with a halogen atom or a straight chain or branched chain alkoxy group having 1 to 20 carbon atoms. R¹ is preferably an aryl group having 6 to 20 carbon atoms, more preferably an aryl group having 6 to 18 carbon atoms, still more preferably an aryl group having 6 to 12 carbon atoms and particularly preferably an aryl group having 6 to 10 carbon atoms. R¹ may be, for example, a phenyl group, a hydrogen atom, a methyl group, an ethyl group, a n-propyl group, an isopropyl group, a n-butyl group, an isobutyl group, a s-butyl group, a t-butyl group, a n-pentyl group, a n-hexyl group, a n-heptyl group, a 2-ethylhexyl group, a n-octyl group, a phenyl group, an o-tolyl group, a m-tolyl group, a p-tolyl group, a 2,4-xylyl group, a 2,6-xylyl group, a 3,5-xylyl group, a mesityl group, a 1-naphthyl group, a 2-naphthyl group or a 4-biphenyl group. When a plurality of R¹s is present, these may be the same as or different from each other.

R² and R³ each independently represent a hydrogen atom; or a chain hydrocarbon group having 1 to 10 carbon atoms in which one or more -CH₂-s may be substituted with -O-. R² and R³ may each independently be, for example, a hydrogen atom, a methyl group, an ethyl group, a n-propyl group, an isopropyl group, a n-butyl group, an isobutyl group, a s-butyl group, a t-butyl group, a n-pentyl group, a n-hexyl group, a n-heptyl group, a 2-ethylhexyl group, a n-octyl group, a 2-ethylbutyl group, a 3,3-dimethylbutyl group, a 1,1,3,3-tetramethylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group or 1-butylhexyl group. Alternatively, R² and R³ bond to each other to form a ring. The ring that is formed by R² and R³ may be, for example, a ring containing a nitrogen atom such as a pyrrolidine ring, a piperidine ring or a morpholine ring. When a plurality of R²s or R³s is present, these may be the same as or different from each other.

X is a halogen atom, PF₆, ClO₄ or BF₄.

The aryl group having 6 to 20 carbon atoms represented by R^{x1} to R^{x4} may be, for example, a phenyl group, an o-tolyl group, a m-tolyl group, a p-tolyl group, a 2,4-xylyl group, a 2,6-xylyl group, a 3,5-xylyl group, a mesityl group, a 2-ethylphenyl group, a 3-ethylphenyl group, a 4-ethylphenyl group, a 2-(n-propyl)phenyl group, a 3-(n-propyl)phenyl group, a 4-(n-propyl)phenyl group, a 2-isopropylphenyl group, a 3-isopropylphenyl group, a 4-isopropylphenyl group, a 2-(n-butyl)phenyl group, a 3-(n-butyl)phenyl group, a 4-(n-butyl)phenyl group, a 2-(s-butyl)phenyl group, a 3-(s-butyl)phenyl group, a 4-(s-butyl)phenyl group, a 2-(t-butyl)phenyl group, a 3-(t-butyl)phenyl group, a 4-(t-butyl)phenyl group, a 4-(n-pentyl)phenyl group, a 4-(n-hexyl)phenyl group, a 4-(n-heptyl)phenyl group, a 4-(2-ethylhexyl)phenyl group, a 4-(n-octyl)phenyl group, a 2-methoxyphenyl group, a 3-methoxyphenyl group, a 4-methoxyphenyl group, a 2-ethoxyphenyl group, a 3-ethoxyphenyl group, a 4-ethoxyphenyl group, a 1-naphthyl group, a 2-naphthyl group, a 4-biphenyl group, a p-terphenyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 4-vinylphenyl group, a 3,5-di(tert-butyl)phenyl group, a 3,5-di(tert-butyl)-4-methylphenyl group, a 2,6-bis(1-methylethyl)phenyl group, a 2,4,6-tris(1-methylethyl)phenyl group, a 4-cyclohexylphenyl group, a 4-(1,1,3,3-tetramethylbutyl)phenyl group, a 6-methyl-2-naphthyl group, a 5,6,7,8-tetrahydro-1-naphthyl group, a 5,6,7,8-tetrahydro-2-naphthyl group, a fluorenyl group, a phenanthryl group, an anthryl group, a 2-dodecylphenyl group, a 3-dodecylphenyl group, a 4-dodecylphenyl group, a phenanthryl group or a fluorenyl group. The aryl group is preferably a phenyl group, an o-tolyl group, a m-tolyl group, a p-tolyl group, a 2,4-xylyl group, a 2,6-xylyl group, a 3,5-xylyl group, a mesityl group, a 4-(t-butyl)phenyl group, a 2-methoxyphenyl group, a 3-methoxyphenyl group or a 4-methoxyphenyl group, more preferably a phenyl group, an o-tolyl group, a m-tolyl group, a p-tolyl group, a 4-(t-butyl)phenyl group, a 2-methoxyphenyl group, a 3-methoxyphenyl group or a 4-methoxyphenyl group and still more preferably a phenyl group.

In the heteroaryl group having 2 to 20 carbon atoms represented by R^{x1} to R^{x4}, one or more hydrogen atoms may be substituted with a halogen atom, -OR¹, -SR¹ or -NR²R³. R¹ to R³ are as defined above. The heteroaryl group having 2 to 20 carbon atoms represented by R^{x1} to R^{x4} may be, for example, a 2-pyrrole group, a 3-pyrrole group, a 2-furanyl group, a 3-furanyl group, a 2-thiophenyl group, a 3-thiophenyl group, a 1-imidazolyl group, a 2-imidazolyl group, a 1-methyl-2-imidazolyl group, a 2-thiazole group, a 3-thiazole group, a 4-thiazole group, a 2-oxazole group, a 3-oxazole group, a 4-oxazole group, a 2-pyridyl group, a 3-pyridyl group, a 4-pyridyl group, a 2-pyrimidyl group, a 2-pyrazyl group, a 5-pyrimidyl group, a 2-benzofuranyl group, a 3-benzofuranyl group, a 2-benzimidazolyl group, a 2-benzothiazole group, a 2-benzoxazole group, a 2-quinolyl group, a 3-quinolyl group, a 4-quinolyl group, a 5-quinolyl group, a 6-quinolyl group, a 7-quinolyl group, a 8-quinolyl group, a 2-benzothienyl group, a 3-benzothienyl group, an indolyl group, a carbazolyl group or an acridinyl group.

In the formula (I), R^{y1} to R^{y4} each independently represent a chain hydrocarbon group having 1 to 20 carbon atoms, an aryl group having 6 to 20 carbon atoms or a heteroaryl group having 2 to 20 carbon atoms. R^{y1} to R^{y4} preferably represent aryl groups having 6 to 20 carbon atoms.

In the chain hydrocarbon group having 1 to 20 carbon atoms represented by R^{y1} to R^{y4}, one or more -CH₂-s may be substituted with -O-, and one or more hydrogen atoms may be substituted with a halogen atom. The chain hydrocarbon group having 1 to 20 carbon atoms represented by R^{y1} to R^{y4} may be, for example, a methyl group, an ethyl group, a n-propyl group, an isopropyl group, a n-butyl group, an isobutyl group, a s-butyl group, a t-butyl group, a n-pentyl group, a n-hexyl group, a n-heptyl group, a 2-ethylhexyl group, a n-octyl group, a 2-ethylbutyl group, a 3,3-dimethylbutyl group, a 1,1,3,3-tetramethylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group or 1-butylhexyl group.

The aryl group having 6 to 20 carbon atoms represented by R^{y1} to R^{y4} is an aryl group preferably having 6 to 18 carbon atoms, more preferably having 6 to 12 carbon atoms and still more preferably having 6 to 10 carbon atoms. In the aryl group, one or more hydrogen atoms may be substituted with a halogen atom, -OR¹, -SR¹ or -NR²R³. R¹ to R³ are as defined above. The aryl group having 6 to 20 carbon atoms represented by R^{y1} to R^{y4} may be, for example, a phenyl group, an o-tolyl group, a m-tolyl group, a p-tolyl group, a 2,4-xylyl group, a 2,6-xylyl group, a 3,5-xylyl group, a mesityl group, a 2-ethylphenyl group, a 3-ethylphenyl group, a 4-ethylphenyl group, a 2-(n-propyl)phenyl group, a 3-(n-propyl)phenyl group, a 4-(n-propyl)phenyl group, a 2-isopropylphenyl group, a 3-isopropylphenyl group, a 4-isopropylphenyl group, a 2-(n-butyl)phenyl group, a 3-(n-butyl)phenyl group, a 4-(n-butyl)phenyl group, a 2-(s-butyl)phenyl group, a 3-(s-butyl)phenyl group, a 4-(s-butyl)phenyl group, a 2-(t-butyl)phenyl group, a 3-(t-butyl)phenyl group, a 4-(t-butyl)phenyl group, a 4-(n-pentyl)phenyl group, a 4-(n-hexyl)phenyl group, a 4-(n-heptyl)phenyl group, a 4-(2-ethylhexyl)phenyl group, a 4-(n-octyl)phenyl group, a 2-methoxyphenyl group, a 3-methoxyphenyl group, a 4-methoxyphenyl group, a 2-ethoxyphenyl group, a 3-ethoxyphenyl group, a 4-ethoxyphenyl group, a 1-naphthyl group, a 2-naphthyl group, a 4-biphenyl group, a p-terphenyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 4-vinylphenyl group, a 3,5-di(tert-butyl)phenyl group, a 3,5-di(tert-butyl)-4-methylphenyl group, a 2,6-bis(1-methylethyl)phenyl group, a 2,4,6-tris(1-methylethyl)phenyl group, a 4-cyclohexylphenyl group, a 4-(1,1,3,3-tetramethylbutyl)phenyl group, a 6-methyl-2-naphthyl group, a 5,6,7,8-tetrahydro-1-naphthyl group, a 5,6,7,8-tetrahydro-2-naphthyl group, a fluorenyl group, a phenanthryl group, an anthryl group, a 2-dodecylphenyl group, a 3-dodecylphenyl group, a 4-dodecylphenyl group, a phenanthryl group or a fluorenyl group. The aryl group is preferably a phenyl group, an o-tolyl group, a m-tolyl group, a p-tolyl group, a 2,4-xylyl group, a 2,6-xylyl group, a 3,5-xylyl group, a mesityl group, a 4-(t-butyl)phenyl group, a 2-methoxyphenyl group, a 3-methoxyphenyl group or a 4-methoxyphenyl group, more preferably a phenyl group or a 4-(t-butyl)phenyl group and still more preferably a 4-(t-butyl)phenyl group.

In the heteroaryl group having 2 to 20 carbon atoms represented by R^{y1} to R^{y4}, one or more hydrogen atoms may be substituted with a halogen atom, -OR¹, -SR¹ or -NR²R³. R¹ to R³ are as defined above. The heteroaryl group having 2 to 20 carbon atoms represented by R^{y1} to R^{y4} may be, for example, a 2-pyrrole group, a 3-pyrrole group, a 2-furanyl group, a 3-furanyl group, a 2-thiophenyl group, a 3-thiophenyl group, a 1-imidazolyl group, a 2-imidazolyl group, a 1-methyl-2-imidazolyl group, a 2-thiazole group, a 3-thiazole group, a 4-thiazole group, a 2-oxazole group, a 3-oxazole group, a 4-oxazole group, a 2-pyridyl group, a 3-pyridyl group, a 4-pyridyl group, a 2-pyrimidyl group, a 2-pyrazyl group, a 5-pyrimidyl group, a 2-benzofuranyl group, a 3-benzofuranyl group, a 2-benzimidazolyl group, a 2-benzothiazole group, a 2-benzoxazole group, a 2-quinolyl group, a 3-quinolyl group, a 4-quinolyl group, a 5-quinolyl group, a 6-quinolyl group, a 7-quinolyl group, a 8-quinolyl group, a 2-benzothienyl group, a 3-benzothienyl group, an indolyl group, a carbazolyl group or an acridinyl group.

In the formula (II), a ring Z¹ and a ring Z² each independently represent an aromatic hydrocarbon ring having 6 to 20 carbon atoms or a heteroaromatic ring having 2 to 20 carbon atoms. The ring Z¹ and the ring Z² are preferably each independently an aromatic hydrocarbon ring having 6 to 20 carbon atoms.

The aromatic hydrocarbon ring having 6 to 20 carbon atoms is an aromatic hydrocarbon ring preferably having 6 to 16 carbon atoms, more preferably having 6 to 14 carbon atoms and still more preferably having 6 to 10 carbon atoms. In the aromatic hydrocarbon ring, one or more hydrogen atoms may be substituted with a halogen atom, a chain hydrocarbon group having 1 to 20 carbon atoms, -OR¹, -SR¹ or -NR²R³. R¹ to R³ are as defined above. The aromatic hydrocarbon ring having 6 to 20 carbon atoms may be, for example, a benzene ring, a 2-methylbenzene ring, a 3-methylbenzene ring, a 2,5-dimethylbenzene ring, a 3,4-dimethylbenzene ring, a 2-ethylbenzene ring, a 3-ethylbenzene ring, a 2,5-diethylbenzene ring, a 3, 4-diethylbenzene ring, a 2-isopropylbenzene ring, a 3-isopropylbenzene ring, a 2,5-diisopropylbenzene ring, a 3,4-diisopropylbenzene ring, a 2-(t-butyl)benzene ring, a 3-(t-butyl)benzene ring, a 2,5-di(t-butyl)benzene ring, a 3,4-di(t-butyl)benzene ring, a 2-phenylbenzene ring, a 3-phenylbenzene ring, a 2,5-diphenylbenzene ring, a 3,4-diphenylbenzene ring, a 2-(4-methylphenyl)benzene ring, a 3-(4-methylphenyl)benzene ring, a 2,5-di(4-methylphenyl)benzene ring, a 3,4-di(4-methylphenyl)benzene ring, a naphthalene ring, an anthracene ring, a phenanthrene ring, a triphenylene ring or a pyrene ring. The aromatic hydrocarbon ring is preferably a benzene ring, a 2-methylbenzene ring, a 3-methylbenzene ring, a 2,5-dimethylbenzene ring, a 3,4-dimethylbenzene ring, a 2,5-diphenylbenzene ring, a 3,4-diphenylbenzene ring or a naphthalene ring, more preferably a benzene ring, a 2,5-dimethylbenzene ring, a 3,4-dimethylbenzene ring, a 2,5-diphenylbenzene ring or a 3,4-diphenylbenzene ring and still more preferably a benzene ring.

In the heteroaromatic ring having 2 to 20 carbon atoms, one or more hydrogen atoms may be substituted with a halogen atom, a chain hydrocarbon group having 1 to 20 carbon atoms, -OR¹, -SR¹ or -NR²R³. R¹ to R³ are as defined above. The heteroaryl group having 2 to 20 carbon atoms may be, for example, a furanyl ring, a benzofuranyl ring, a pyridyl ring, a pyrimidinyl ring, a pyrazinyl ring, a pyridazinyl ring, a thienyl ring, a benzothienyl ring, an oxazolyl ring, a benzoxazolyl ring, a thiazolyl ring, a benzothiazolyl ring, an indolyl ring, a carbazolyl ring, an acridinyl ring, an imidazolyl ring, a benzimidazolyl ring, a quinolyl ring or an isoquinolyl ring.

In the formula (I) and the formula (II), M² represents a divalent metal atom. From the viewpoint of obtaining excellent optical characteristics and the viewpoint of easy procurement, M² is preferably Ru, Fe, Cu, Zn, Co, Ni or Pd and more preferably Ru.

Specific examples of the compound represented by the formula (I) include a compound represented by the following formula. The compound represented by the following formula is the compound represented by the formula (I) in which R^{x1} to R^{x4} are phenyl groups, R^{y1} to R^{y4} are 4-(t-butyl)phenyl groups and M² is Ru. Such a compound may have the absorption maximum at, for example, 720 to 820 nm or 760 to 780 nm.

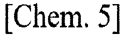

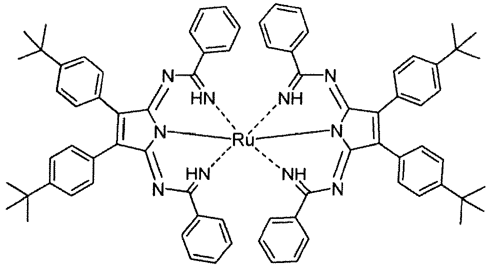

Specific examples of the compound represented by the formula (II) include a compound represented by the following formula. The compound represented by the following formula is the compound represented by the formula (II) in which R^{x1} to R^{x4} are phenyl groups, Z' and the ring Z² are benzene rings and M² is Ru. Such a compound may have the absorption maximum at, for example, 700 to 760 nm or 700 to 720 nm.

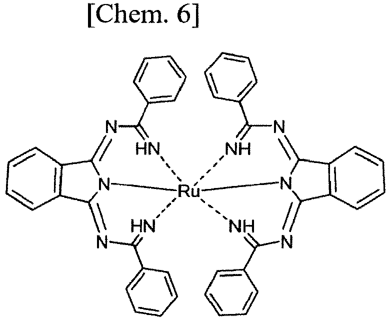

The compound represented by the formula (III) and the compound represented by the formula (IV) are as follows.

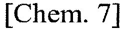

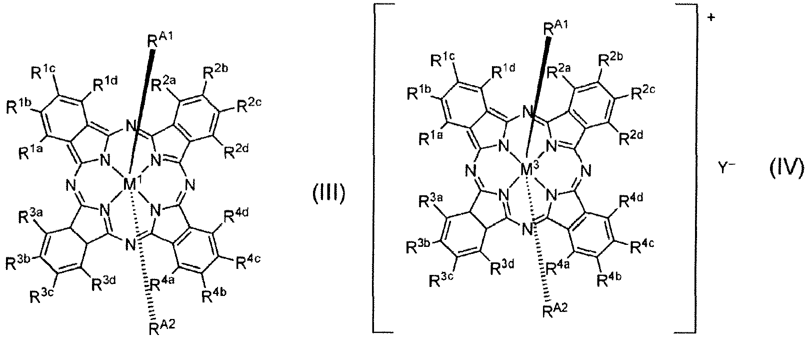

In the formula (III) and the formula (IV), R^{1a} to R^{1d}, R^{2a} to R^{2d}, R^{3a} to R^{3d} and R^{4a} to R^{4d} (hereinafter, these will be collectively referred to as R^{1a} to R^{4d} in some cases) each independently represent a hydrogen atom, a halogen atom, a chain hydrocarbon group having 1 to 20 carbon atoms, -OR¹, -SR¹ or -NR²R³. R¹ to R³ are as defined above.

The halogen atom represented by R^{1a} to R^{4d} may be, for example, fluorine, chlorine, bromine or iodine.

The chain hydrocarbon group having 1 to 20 carbon atoms represented by R^{1a} to R^{4d} may be, for example, a methyl group, an ethyl group, a n-propyl group, an isopropyl group, a n-butyl group, an isobutyl group, a s-butyl group, a t-butyl group, a n-pentyl group, a n-hexyl group, a n-heptyl group, a 2-ethylhexyl group, a n-octyl group, a 2-ethylbutyl group, a 3,3-dimethylbutyl group, a 1,1,3,3-tetramethylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group or 1-butylhexyl group.

At least one of R^{1a} to R^{4d} represents -SR'. Preferably, R^{1a}, R^{1d}, R^{2a}, R^{2d}, R^{3a}, R^{3d}, R^{4a} and R^{4d} represent -SR¹ and R^{1b}, R^{1c}, R^{2b}, R^{2c}, R^{3b}, R^{3c}, R^{4b} and R^{4c} represent a hydrogen atom. Here, -SR¹ is preferably -SPh.

In the formula (III) and the formula (IV), R^{A1} and R^{A2} each independently represent -OR⁴. R⁴ represents a hydrogen atom, a chain hydrocarbon group having 1 to 10 carbon atoms, an aryl group having 6 to 20 carbon atoms or a heteroaryl group having 2 to 20 carbon atoms. R⁴ is preferably a hydrogen atom or a chain hydrocarbon group having 1 to 10 carbon atoms.

In the chain hydrocarbon group having 1 to 10 carbon atoms represented by R⁴, one or more -CH₂-s may be substituted with -O-, -NR⁵- or -N⁺(R⁵R⁶)X⁻-.

R⁵ and R⁶ each independently represent a hydrogen atom or a chain hydrocarbon group having 1 to 10 carbon atoms. R⁵ and R⁶ may each independently be, for example, a methyl group, an ethyl group, an n-propyl group, an isopropyl group, an n-butyl group, an isobutyl group, a s-butyl group, a t-butyl group, an n-pentyl group, an n-hexyl group, an n-heptyl group, a 2-ethylhexyl group or an n-octyl group. When a plurality of R⁵s or R⁶s is present, these may be the same as or different from each other.

The chain hydrocarbon group having 1 to 10 carbon atoms which is represented by R⁴ and in which one or more -CH₂-s may be substituted with -O-, -NR⁵- or -N⁺(R⁵R⁶)X- may be, for example, a methyl group, -CH₂CH₂OCH₃, -CH₂CH₂OCH₂CH₃, -CH₂CH₂OCH₂CH₂OCH₃, -CH₂CH₂OCH₂CH₂OCH₂CH₃, -CH₂CH₂OCH₂CH₂OCH₂CH₃OCH₃, -CH₂CH₂N⁺(CH₃)₃ I⁻, -CH₂CH₂N⁺(CH₃)₂CH₂CH₃ I⁻, -CH₂CH₂N⁺(CH₂CH₃)₃ I⁻ or -CH₂CH₂OCH₂CH₂N⁺(CH₃)₃ I⁻.

In the formula (III), M¹ represents a tetravalent metal atom or a non-metal atom. M¹ may be, for example, Si, Ge or Sn. From the viewpoint of obtaining excellent optical characteristics, M¹ is preferably Si. In the formula (IV), M³ represents a pentavalent metal atom or a non-metal atom. M³ may be, for example, P, As or Sb. From the viewpoint of obtaining excellent optical characteristics, M³ is preferably P.

In the formula (IV), Y⁻ represents a monovalent anion. Y⁻ is not particularly limited and may be, for example, a halide ion, a hexafluorophosphate ion, a perchlorate ion, a tetrafluoroborate ion, a benzenesulfonate ion or a p-toluenesulfonate ion.

Specific examples of the compound represented by the formula (III) include compounds represented by the following formula. The compounds represented by the following formula are the compounds represented by the formula (III) in which R^{1a}, R^{1d} , R^{2a}, R^{2d}, R^{3a}, R^{3d}, R^{4a} and R^{4d} are -SPh, R^{1b}, R^{1c}, R^{2b}, R^{2c}, R^{3b}, R^{3c}, R^{4b} and R^{4c} are hydrogen atoms and M¹ is Si.

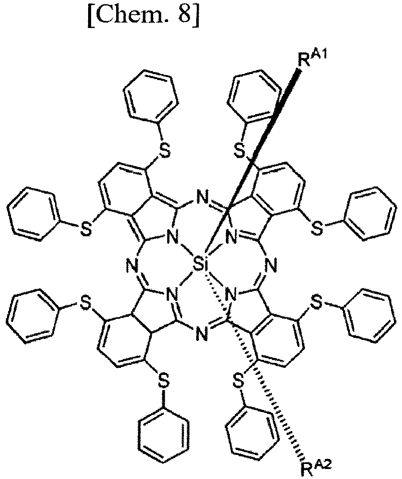

In the above formula, R^{A1} and R^{A2} are any of the groups represented by the following formulae.

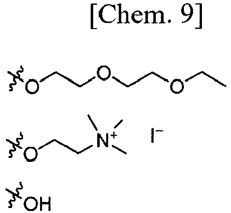

A compound of the above formula in which R^{A1} and R^{A2} are -OCH₂CH₂OCH₂CH₂OCH₂CH₃ may have the absorption maximum at, for example, 730 to 890 nm or 780 to 840 nm. A compound of the above formula in which R^{A1} and R^{A2} are -OCH₂CH₂N⁺(CH₃)₃ I⁻ may have the absorption maximum at, for example, 730 to 950 nm or 770 to 830 nm.

Specific examples of the compound represented by the formula (IV) include a compound represented by the following formula. The compound represented by the following formula is the compound represented by the formula (IV) in which R^{1a}, R^{1d}, R^{2a}, R^{2d}, R^{3a}, R^{3d}, R^{4a} and R^{4d} are -SPh, R^{1b}, R^{1c}, R^{1b}, R^{2c}, R^{3b}, R^{3c}, R^{4b} and R^{4c} are hydrogen atoms, R^{A1} and R^{A2} are methoxy groups and M³ is P. Such a compound may have the absorption maximum at, for example, 965 to 1065 nm or 980 to 1050 nm.

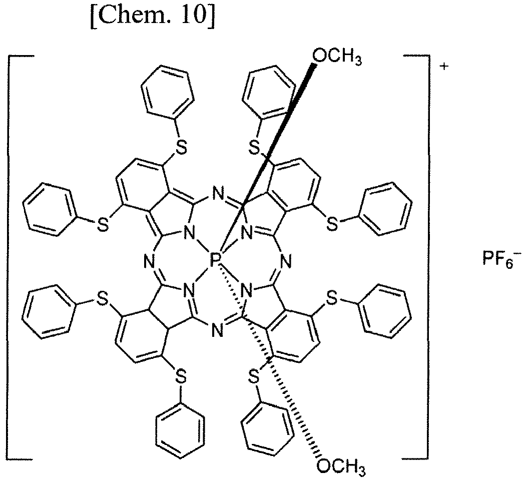

The compound represented by the formula (I), the formula (II), the formula (III) or the formula (IV) is a compound that absorbs near-infrared rays of a specific wavelength and transmits visible light. In the present specification, near-infrared rays refer to light having wavelengths of 700 nm to 3 µm. The compound represented by the formula (I), the formula (II), the formula (III) or the formula (IV) has the absorption maximum preferably at 700 nm to 2500 nm, more preferably 700 nm to 1500 nm and still more preferably 700 nm to 1300 nm. The compound represented by the formula (I) may have the absorption maximum at, for example, 720 to 820 nm or 760 to 780 nm. The compound represented by the formula (II) may have the absorption maximum at, for example, 700 to 760 nm or 700 to 720 nm. The compound represented by the formula (III) may have the absorption maximum at, for example, 730 to 890 nm, 780 to 840 nm, 730 to 950 nm or 770 to 830 nm. The compound represented by the formula (IV) may have the absorption maximum at, for example, 965 to 1065 nm or 980 to 1050 nm.

The average value of transmittance at 450 nm to 650 nm (that is, visible light) of the compound represented by the formula (I), the formula (II), the formula (III) or the formula (IV) is preferably, for example, 98.0% or more, 98.3% or more, 98.5% or more or 99.0% or more. In the present specification, transmittance was measured using V-770 (UV - Visible/NIR spectrophotometer) manufactured by JASCO Corporation at a wavelength of 300 to 1400 nm and measurement intervals of 5.0 nm. Transmittance was measured after reference measurement with a glass substrate.

From the viewpoint of obtaining the resin composition excellent in heat resistance and visible light transmission, the coloring agent (A1) is preferably the compound represented by the formula (I) or the formula (II).

The content of the coloring agent (Al) is preferably 20 to 100 mass%, more preferably 30 to 100 mass% and still more preferably 40 to 100 mass% in the total amount of the coloring agent (A).

The content of the coloring agent (Al) may be 0.5 to 60 mass%, 0.9 to 60 mass%, 2 to 60 mass%, 4 to 55 mass% or 6 to 50 mass% in the total amount of the solid content of the resin composition. In the present specification, "the total amount of the solid content" refers to the total amount of the components of the resin composition excluding solvents. The total amount of the solid content and the content of each component with respect to this can be measured by, for example, known analytical means such as liquid chromatography or gas chromatography.

The coloring agent (A) may further contain a coloring agent different from the coloring agent (A1) (hereinafter, also referred to as the coloring agent (A2)). The coloring agent (A2) may be a dye or a pigment.

Examples of the dye include compounds except for pigments that are classified as having a hue in the Colour Index (published by The Society of Dyers and Colourists), and known dyes that are described in Dyeing Note (Shikisensha Co., Ltd.). As the dye, a xanthene dye is preferable.

The xanthene dye is a dye containing a compound having a xanthene skeleton. Examples of the xanthene dye include C.I. Acid Red 51, 52, 87, 92, 94, 289 and 388; C.I. Acid Violet 9, 30 and 102; C.I. Basic Red 1 (rhodamine 6G), 2, 3, 4, 8, 10 and 11; C.I. Basic Violet 10 (rhodamine B) and 11; C.I. Solvent Red 218; C.I. Mordant Red 27; C.I. Reactive Red 36 (rose bengal B); sulforhodamine G; xanthene dyes described in Japanese Unexamined Patent Application Publication No. 2010-32999; and xanthene dyes described in Japanese Patent No. 4492760. The xanthene dye is preferably a xanthene dye that dissolves in an organic solvent.

As the xanthene dye, it is possible to use commercially available xanthene dyes such as "Chugai Aminol Fast Pink R-H/C" manufactured by Chugai Kasei Co., LTD. and "Rhodamin 6G" manufactured by Taoka Chemical Co., Ltd. In addition, as the xanthene dye, it is also possible to use xanthene dyes that are synthesized according to a method described in Japanese Unexamined Patent Application Publication No. 2010-32999 using a commercially available xanthene dye as a starting raw material.

As other dyes, known azo dyes, cyanine dyes, triphenylmethane dyes, thiazole dyes, oxazine dyes, phthalocyanine dyes, quinophthalone dyes, anthraquinone dyes, naphthoquinone dyes, quinoneimine dyes, methine dyes, azomethine dyes, squarylium dyes, acridine dyes, styryl dyes, coumarin dyes, quinoline dyes, nitro dyes and the like may also be used. Examples of such dyes include C.I. solvent dyes, C.I. acid dyes, C.I. direct dyes, C.I. disperse dyes, C.I. basic dyes, C.I. reactive dyes, C.I. mordant dyes and C.I. vat dyes.

Examples of C.I. solvent dyes include C.I. Solvent Yellow 4, 14, 15, 23, 24, 38, 62, 63, 68, 82, 94, 98, 99, 117, 162, 163, 167 and 189; C.I. Solvent Red 45, 49, 111, 125, 130, 143, 145, 146, 150, 151, 155, 168, 169, 172, 175, 181, 207, 222, 227, 230, 245 and 247; C.I. Solvent Orange 2, 7, 11, 15, 26, 56, 77 and 86; C.I. Solvent Violet 11, 13, 14, 26, 31, 36, 37, 38, 45, 47, 48, 51, 59 and 60; C.I. Solvent Blue 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136 and 139; and C.I. Solvent Green 1, 3, 4, 5, 7, 28, 29, 32, 33, 34 and 35.

Examples of C.I. acid dyes include C.I. Acid Yellow 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243 and 251; C.I. Acid Red 1, 4, 8, 14, 17, 18, 26, 27, 29, 31, 33, 34, 35, 37, 40, 42, 44, 50, 57, 66, 73, 76, 80, 88, 91, 95, 97, 98, 103, 106, 111, 114, 129, 133, 134, 138, 143, 145, 150, 151, 155, 158, 160, 172, 176, 182, 183, 195, 198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422 and 426; C.I. Acid Orange 6, 7, 8, 10, 12, 26, 50, 51, 52, 56, 62, 63, 64, 74, 75, 94, 95, 107, 108, 169 and 173; C.I. Acid Violet 6B, 7, 15, 16, 17, 19, 21, 23, 24, 25, 34, 38, 49 and 72; C.I. Acid Blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335 and 340; and C.I. Acid Green 1, 3, 5, 6, 7, 8, 9, 11, 13, 14, 15, 16, 22, 25, 27, 28, 41, 50, 50:1, 58, 63, 65, 80, 104, 105, 106 and 109.

Examples of C.I. direct dyes include C.I. Direct Yellow 2, 33, 34, 35, 38, 39, 43, 47, 50, 54, 58, 68, 69, 70, 71, 86, 93, 94, 95, 98, 102, 108, 109, 129, 136, 138 and 141; C.I. Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246 and 250; C.I. Direct Orange 26, 34, 39, 41, 46, 50, 52, 56, 57, 61, 64, 65, 68, 70, 96, 97, 106 and 107; C.I. Direct Violet 47, 52, 54, 59, 60, 65, 66, 79, 80, 81, 82, 84, 89, 90, 93, 95, 96, 103 and 104; C.I. Direct Blue 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275 and 293; and C.I. Direct Green 25, 27, 31, 32, 34, 37, 63, 65, 66, 67, 68, 69, 72, 77, 79 and 82.

Examples of C.I. disperse dyes include C.I. Disperse Yellow 51, 54 and 76; C.I. Disperse Violet 26 and 27; and C.I. Disperse Blue 1, 14, 56 and 60.

Examples of C.I. basic dyes include C.I. Basic Blue 1, 3, 5, 7, 9, 19, 21, 22, 24, 25, 26, 28, 29, 40, 41, 45, 47, 54, 58, 59, 60, 64, 65, 66, 67, 68, 81, 83, 88 and 89; C.I. Basic Violet 2; C.I. Basic Red 9; and C.I. Basic Green 1.

Examples of C.I. reactive dyes include C.I. Reactive Yellow 2, 76 and 116; C.I. Reactive Orange 16; and C.I. Reactive Red 36.

Examples of C.I. mordant dyes include C.I. Mordant Yellow 5, 8, 10, 16, 20, 26, 30, 31, 33, 42, 43, 45, 56, 61, 62 and 65; C.I. Mordant Red 1, 2, 3, 4, 9, 11, 12, 14, 17, 18, 19, 22, 23, 24, 25, 26, 29, 30, 32, 33, 36, 37, 38, 39 , 41, 42, 43, 45, 46, 48, 52, 53, 56, 62, 63, 71, 74, 76, 78, 85, 86, 88, 90, 94 and 95; C.I. Mordant Orange 3, 4, 5, 8, 12, 13, 14, 20, 21, 23, 24, 28, 29, 32, 34, 35, 36, 37, 42, 43, 47 and 48; C.I. Mordant Violet 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53 and 58; C.I. Mordant Blue 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83 and 84; and C.I. Mordant Green 1, 3, 4, 5, 10, 13, 15, 19, 21, 23, 26, 29, 31, 33, 34, 35, 41, and 43.

Examples of C.I. vat dyes include C.I. Vat Green 1.

Examples of the pigment include pigments that are classified as pigments in the Colour Index (published by The Society of Dyers and Colourists).

Examples of the pigment include green pigments, yellow pigments, orange pigments, red pigments, blue pigments and violet pigments. Examples of green pigments include C.I. Pigment Green 7, 36 and 58. Examples of yellow pigments include C.I. Pigment Yellow 1, 3, 12, 13, 14, 15, 16, 17, 20, 24, 31, 53, 83, 86, 93, 94, 109, 110, 117, 125, 128, 129, 137, 138, 139, 147, 148, 150, 153, 154, 166, 173, 185, 194 and 214. Examples of orange pigments include C.I. Pigment Orange 13, 31, 36, 38, 40, 42, 43, 51, 55, 59, 61, 64, 65, 71 and 73. Examples of red pigments include C.I. Pigment Red 9, 97, 105, 122, 123, 144, 149, 166, 168, 176, 177, 180, 192, 209, 215, 216, 224, 242, 254, 255, 264 and 265. Examples of blue pigments include C.I. Pigment Blue 15, 15:3, 15:4, 15:6 and 60. Examples of violet pigments include C.I. Pigment Violet 1, 19, 23, 29, 32, 36 and 38. Regarding each color, one pigment or a plurality of pigments may be used, and pigments of a plurality of colors may be combined.

On the pigment, a treatment such as a rosin treatment, a surface treatment using a pigment derivative into which an acidic group or a basic group has been introduced, a graft treatment on the surface of the pigment with a polymer compound, an atomization treatment by a sulfuric acid atomization method or the like, a washing treatment with an organic solvent or water for removing impurities, or a removal treatment of ionic impurities by an ion exchange method may be performed as necessary. The grain diameters of the pigment are preferably substantially uniform.

The pigment, by adding a pigment dispersant and performing a dispersion treatment, can be made into a pigment dispersion liquid in a state where the pigment is uniformly dispersed in a pigment dispersant solution. The pigments may each individually be dispersion-treated, or a plurality of pigments may be mixed and dispersion-treated. In a case of using the pigment dispersant, the amount thereof used is preferably 10 parts by mass or more and 200 parts by mass or less, more preferably 15 parts by mass or more and 180 parts by mass or less and still more preferably 20 parts by mass or more and 160 parts by mass or less, with respect to 100 parts by mass of the pigment. When the amount of the pigment dispersant used is within the above-described ranges, in a case of using two or more pigments, there is a tendency that a pigment dispersion liquid in which the pigments are more uniformly dispersed can be obtained.

In a case where the coloring agent (A) contains the coloring agent (A2), the content of the coloring agent (A2) is preferably 1 to 80 mass%, more preferably 1 to 70 mass% and still more preferably 1 to 60 mass% in the total amount of the coloring agent (A).

The content of the coloring agent (A) in the resin composition may be, for example, 0.5 mass% or more and 70 mass% or less, 0.9 mass% or more and 70 mass% or less, 1 mass% or more and 70 mass% or less, 2 mass% or more and 65 mass% or less, 5 mass% or more and 60 mass% or less or 7 mass% or more and 55 mass% or less, with respect to the total amount of the solid content. When the content of the coloring agent (A) is within the above-described ranges, it becomes easier to obtain desired spectral characteristics.

### <Resin (B)>

The resin (B) is not particularly limited, but is preferably an alkali-soluble resin. Examples of the resin (B) include the following resins [K1] to [K6]:
a resin [K1] which is a copolymer having a structural unit derived from at least one (a) selected from the group consisting of an unsaturated carboxylic acid and an unsaturated carboxylic acid anhydride (hereinafter referred to as "(a)" in some cases), and a structural unit derived from a monomer (b) having a cyclic ether structure having 2 to 4 carbon atoms and an ethylenic unsaturated bond (hereinafter referred to as "(b)" in some cases);
a resin [K2] which is a copolymer having a structural unit derived from (a), a structural unit derived from (b) and a structural unit derived from a monomer (c) that can copolymerize with (a) (but different from (a) and (b)) (hereinafter referred to as "(c)" in some cases);
a resin [K3] which is a copolymer having a structural unit derived from (a) and a structural unit derived from (c);
a resin [K4] which is a copolymer having a structural unit in which (b) has been added to a structural unit derived from (a), and a structural unit derived from (c);
a resin [K5] which is a copolymer having a structural unit in which (a) has been added to a structural unit derived from (b), and a structural unit derived from (c); or
a resin [K6] which is a copolymer having a structural unit in which (a) has been added to a structural unit derived from (b) and a carboxylic acid anhydride has further been added, and a structural unit derived from (c). Among these, the resin (B) is preferably a copolymer having a structural unit derived from at least one selected from the group consisting of an unsaturated carboxylic acid and an unsaturated carboxylic acid anhydride, and a structural unit derived from a monomer having a cyclic ether structure having 2 to 4 carbon atoms and an ethylenic unsaturated bond (that is, the resin K1 or K2), and more preferably the resin K2.

Specific examples of (a) include unsaturated monocarboxylic acids such as acrylic acid, methacrylic acid, crotonic acid, and o-, m-, p-vinylbenzoic acid; unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid and 1,4-cyclohexenedicarboxylic acid; bicyclo unsaturated compounds containing a carboxy group, such as methyl-5-norbomene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene and 5-carboxy-6-ethylbicyclo[2.2.1]hept-2-ene; unsaturated dicarboxylic acid anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride and 5,6-dicarboxybicyclo[2.2.1]hept-2-ene anhydride; unsaturated mono[(meth)acryloyloxyalkyl] esters of polyvalent (divalent or higher) carboxylic acids such as mono[2-(meth)acryloyloxyethyl] succinate and mono[2-(meth)acryloyloxyethyl] phthalate; unsaturated acrylates containing a hydroxy group and a carboxy group, such as α-(hydroxymethyl)acrylic acid; and the like. Among these, in terms of copolymerization reactivity and from the viewpoint of the solubility of a resin to be obtained in an alkaline aqueous solution, acrylic acid, methacrylic acid or maleic anhydride is preferable as (a).

The cyclic ether structure having 2 to 4 carbon atoms contained in the monomer (b) may be, for example, at least one selected from the group consisting of an oxirane ring, an oxetane ring and a tetrahydrofuran ring. (b) preferably has the cyclic ether structure having 2 to 4 carbon atoms and a (meth)acryloyloxy group. In the present specification, "(meth)acrylic acid" represents at least one selected from the group consisting of acrylic acid and methacrylic acid, "(meth)acryloyl" represents at least one selected from the group consisting of acryloyl and methacryloyl, and "(meth)acrylate" represents at least one selected from the group consisting of acrylate and methacrylate.

(b) may be, for example, a monomer (b1) having an oxiranyl group and an ethylenic unsaturated bond (hereinafter referred to as "(b1)" in some cases), a monomer (b2) having an oxetanyl group and an ethylenic unsaturated bond (hereinafter referred to as "(b2)" in some cases) or a monomer (b3) having a tetrahydrofuryl group and an ethylenic unsaturated bond (hereinafter referred to as "(b3)" in some cases).

Examples of (b1) include a monomer (b1-1) having a structure in which a straight chain or branched chain aliphatic unsaturated hydrocarbon has been epoxidized (hereinafter referred to as "(b1-1)" in some cases), or a monomer (b1-2) having a structure in which an alicyclic unsaturated hydrocarbon has been epoxidized (hereinafter referred to as "(b1-2)" in some cases).

Examples of (bl-1) include glycidyl (meth)acrylate, β-methylglycidyl (meth)acrylate, β-ethylglycidyl (meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl) styrene, 2,6-bis(glycidyloxymethyl)styrene, 2,3,4-tris(glycidyloxymethyl) styrene, 2,3,5-tris(glycidyloxymethyl)styrene, 2,3,6-tris(glycidyloxymethyl) styrene, 3,4,5-tris(glycidyloxymethyl)styrene and 2,4,6-tris(glycidyloxymethyl) styrene.

Examples of (b1-2) include vinylcyclohexene monoxide, 1,2-epoxy-4-vinylcyclohexane (for example, CELLOXIDE 2000, manufactured by Daicel Corporation), 3,4-epoxycyclohexylmethyl (meth)acrylate (for example, CYCLOMER A400, manufactured by Daicel Corporation), 3,4-epoxycyclohexylmethyl (meth)acrylate (for example, CYCLOMER M100, manufactured by Daicel Corporation), 3.4-epoxytricyclo[5.2.0^{2,6}]decyl (meth)acrylate and 3,4-epoxytricyclo[5.2.1.0^{2,6}]decyloxyethyl (meth)acrylate.

As (b2), a monomer having an oxetanyl group and a (meth)acryloyloxy group is preferable, and examples of such (b2) include 3 -methyl-3 -methacryloyloxymethyloxetane, 3-methyl-3-acryloyloxymethyloxetane, 3-ethyl-3-methacryloyloxymethyloxetane, 3-ethyl-3-acryloyloxymethyloxetane, 3-methyl-3-methacryloyloxyethyloxetane, 3-methyl-3-acryloyloxyethyloxetane, 3-ethyl-3-methacryloyloxyethyloxetane and 3-ethyl-3-acryloyloxyethyloxetane.

As (b3), a monomer having a tetrahydrofuryl group and a (meth)acryloyloxy group is preferable, and examples of such (b3) include tetrahydrofurfuryl acrylate (for example, VISCOAT V#150, manufactured by Osaka Organic Chemical Industry Ltd.) and tetrahydrofurfuryl methacrylate.

From the viewpoint of further enhancing the reliability, such as heat resistance and chemical resistance, of optical filters, (b) is preferably (b1). Furthermore, from the viewpoint of obtaining a resin composition excellent in storage stability, (b) is more preferably (b1-2).

Examples of (c) include (meth)acrylic esters such as methyl (meth)acrylate, ethyl (meth)acrylate, n-butyl (meth)acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, tricyclo[5.2.1.0^{2,6}]decan-8-yl (meth)acrylate (referred to as "dicyclopentanyl (meth)acrylate" as a common name in the technical field. In addition, also referred to as "tricyclodecyl (meth)acrylate" in some cases.), tricyclo[5.2.1.0^{2,6}]decen-8-yl (meth)acrylate (referred to as "dicyclopentenyl (meth)acrylate" as a common name in the technical field), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, and benzyl (meth)acrylate;
hydroxy group-containing (meth)acrylic esters such as 2-hydroxyethyl (meth)acrylate and 2-hydroxypropyl (meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide; and
styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, 2,3-dimethyl-1,3-butadiene and the like.

Among these, from the viewpoint of copolymerization reactivity and heat resistance, styrene, vinyltoluene, N-phenylmaleimide, N-cyclohexylmaleimide, N-benzylmaleimide or bicyclo[2.2.1]hept-2-ene is preferable.

In the resin [K1], with respect to the total mole number of all structural units constituting the resin [K1],
it is preferable that
   the structural unit derived from (a) is 2 to 60 mol% and
   the structural unit derived from (b) is 40 to 98 mol%, and
it is more preferable that
   the structural unit derived from (a) is 10 to 50 mol% and
   the structural unit derived from (b) is 50 to 90 mol%.

When the ratio of each structural unit of the resin [K1] is within the above-described ranges, there is a tendency that the storage stability of the resin composition, developability at the time of forming a coloring pattern described below, and solvent resistance of an optical filter are excellent.

The resin [K1] can be manufactured with reference to a method described in, for example, a document "Experimental Method for Polymer Synthesis" (written by Takayuki Otsu, published by Kagaku-Dojin Publishing Company, INC, 1st Edition, 1st Printing, published on March 1, 1972) and documents cited in the above-described document.

Specifically, examples include a method in which predetermined amounts of (a) and (b), a polymerization initiator, a solvent and the like are put into a reaction vessel, heated and kept warm while being stirred in, for example, a nitrogen atmosphere. Note that the polymerization initiator, the solvent and the like that are used here are not particularly limited, and it is possible to use polymerization initiators, solvents and the like that are commonly used in the field. For example, examples of the polymerization initiator include azo compounds (2,2'-azobisisobutyronitrile, 2,2'-azobis(2,4-dimethylvaleronitrile) and the like) or organic peroxides (benzoyl peroxide and the like). The solvent is not particularly limited as long as the solvent dissolves monomers, and it is possible to use, for example, solvents described as the solvent (E) of the resin composition.

In the resin [K2], with respect to the total mole number of all structural units constituting the resin [K2],
it is preferable that
   the structural unit derived from (a) is 2 to 45 mol%,
   the structural unit derived from (b) is 2 to 95 mol% and
   the structural unit derived from (c) is 1 to 65 mol%, and
it is more preferable that
   the structural unit derived from (a) is 5 to 40 mol%,
   the structural unit derived from (b) is 5 to 80 mol% and
   the structural unit derived from (c) is 5 to 60 mol%.

When the ratio of each structural unit of the resin [K2] is within the above-described ranges, there is a tendency that the storage stability of the resin composition, developability at the time of forming a coloring pattern, and solvent resistance, heat resistance and a mechanical strength of an optical filter are excellent.

The resin [K2] can be manufactured, for example, by the same method as the resin [K1] except that (a), (b) and (c) are used instead of (a) and (b).

In the resin [K3], with respect to the total mole number of all structural units constituting the resin [K3],
it is preferable that
   the structural unit derived from (a) is 2 to 60 mol% and
   the structural unit derived from (c) is 40 to 98 mol%, and
it is more preferable that
   the structural unit derived from (a) is 10 to 50 mol% and
   the structural unit derived from (c) is 50 to 90 mol%.

The resin [K3] can be manufactured, for example, by the same method as the resin [K1] except that (a) and (c) are used instead of (a) and (b).

The resin [K4] can be manufactured by obtaining a copolymer of (a) and (c), and adding the cyclic ether having 2 to 4 carbon atoms contained in (b) to the carboxylic acid and/or carboxylic acid anhydride of (a). First, the copolymer of (a) and (c) is manufactured by the same method as the resin [K3]. The ratio of the structural unit derived from (a) and the structural unit derived from (c) is preferably the same as the resin [K3]. Next, the cyclic ether having 2 to 4 carbon atoms contained in (b) is reacted with some of the carboxylic acid and/or carboxylic acid anhydride derived from (a) in the copolymer. Specifically, subsequent to the manufacturing of the copolymer of (a) and (c), nitrogen in the atmosphere in a flask is substituted with an air, and (b), a reaction catalyst for the carboxylic acid or carboxylic acid anhydride and the cyclic ether (for example, tris(dimethylaminomethyl)phenol or the like), a polymerization inhibitor (for example, hydroquinone or the like) and the like are put into the flask and reacted, for example, at 60°C to 130°C for one to 10 hours, whereby the resin [K4] can be manufactured. The charging method and the reaction conditions such as the reaction temperature and the reaction time can be adjusted as appropriate in consideration of the manufacturing facility, the amount of heat generated by the polymerization, and the like.

The amount of (b) used is preferably 5 to 80 mol and more preferably 10 to 75 mol, with respect to 100 mol of (a). By setting the amount of (b) used within this range, there is a tendency that the storage stability of the resin composition, developability at the time of forming a coloring pattern, and the balance of solvent resistance, heat resistance, a mechanical strength and sensitivity of an optical filter becomes favorable. Since the reactivity of the cyclic ether is high and unreacted (b) is less likely to remain, (bl) is preferable as (b) used for the resin [K4], and (b 1-1) is more preferable.

The amount of the reaction catalyst used is preferably 0.001 to 5 parts by mass or less with respect to 100 parts by mass of the total amount of (a), (b) and (c). The amount of the polymerization inhibitor used is preferably 0.001 to 5 parts by mass with respect to 100 parts by mass of the total amount of (a), (b) and (c).

The resin [K5] can be manufactured by the same method as the resin [K4] except that (b) is used instead of (a) and (a) is used instead of (b). That is, first, a copolymer of (b) and (c) is obtained, and then the carboxylic acid or carboxylic acid anhydride derived from (a) is reacted with the cyclic ether derived from (b) that the copolymer of (b) and (c) has, whereby the resin K5 can be obtained. Here, regarding the ratio of the structural unit derived from (b) and the structural unit derived from (c), with respect to the total mole number of all structural units constituting the above-described copolymer,
it is preferable that
   the structural unit derived from (b) is 5 to 95 mol% and
   the structural unit derived from (c) is 5 to 95 mol%, and
it is more preferable that
   the structural unit derived from (b) is 10 to 90 mol% and
   the structural unit derived from (c) is 10 to 90 mol%.

In addition, the amount of (a) to be reacted with the copolymer used is preferably 5 to 80 mol with respect to 100 mol of (b). Since the reactivity of the cyclic ether is high and unreacted (b) is less likely to remain, (b1) is preferable as (b) used for the resin [K5], and (b1-1) is more preferable.

The resin [K6] is a resin obtained by further reacting a carboxylic acid anhydride with the resin [K5]. Specifically, a carboxylic acid anhydride is reacted with a hydroxy group that is generated by a reaction between the cyclic ether derived from (b) and the carboxylic acid or carboxylic acid anhydride derived from (a). Examples of the carboxylic acid anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride and 5,6-dicarboxybicyclo[2.2.1]hept-2-ene anhydride. The amount of the carboxylic acid anhydride used is preferably 0.5 to 1 mol with respect to 1 mol of the amount of (a) used.

Specific examples of the resin (B) include the resin [K1] such as a 3,4-epoxycyclohexylmethyl (meth)acrylate/(meth)acrylic acid copolymer and a 3,4-epoxytricyclo[5.2.1.0^{2.6}]decyl acrylate/(meth)acrylic acid copolymer; the resin [K2] such as a glycidyl (meth)acrylate/benzyl (meth)acrylate/(meth)acrylic acid copolymer, a glycidyl (meth)acrylate/styrene/(meth)acrylic acid copolymer, a 3,4-epoxytricyclo[5.2.1.0^{2,6}]decyl acrylate/(meth)acrylic acid/N-cyclohexylmaleimide copolymer, a 3,4-epoxytricyclo[5.2.1.0^{2,6}]decyl acrylate/(meth)acrylic acid/N-cyclohexylmaleimide/2-hydroxyethyl (meth)acrylate copolymer, a 3-methyl-3-(meth)acryloyloxymethyloxetane/(meth)acrylic acid/styrene copolymer and a benzyl (meth)acrylate/(meth)acrylic acid/3,4-epoxytricyclo[5.2.1.0^{2,6}]decyl acrylate copolymer; the resin [K3] such as a benzyl (meth)acrylate/(meth)acrylic acid copolymer and a styrene/(meth)acrylic acid copolymer; the resin [K4] such as a resin in which glycidyl (meth)acrylate has been added to a benzyl (meth)acrylate/(meth)acrylic acid copolymer, a resin in which glycidyl (meth)acrylate has been added to a tricyclodecyl (meth)acrylate/styrene/(meth)acrylic acid copolymer, and a resin in which glycidyl (meth)acrylate has been added to a tricyclodecyl (meth)acrylate/benzyl (meth)acrylate/(meth)acrylic acid copolymer; the resin [K5] such as a resin in which (meth)acrylic acid has been reacted with a copolymer of tricyclodecyl (meth)acrylate/glycidyl (meth)acrylate, and a resin in which (meth)acrylic acid has been reacted with a copolymer of tricyclodecyl (meth)acrylate/styrene/glycidyl (meth)acrylate; the resin [K6] such as a resin in which tetrahydrophthalic anhydride has been further reacted with a resin in which (meth)acrylic acid has been reacted with a copolymer of tricyclodecyl (meth)acrylate/glycidyl (meth)acrylate; and the like.

The resin [K2] may be, for example, a benzyl methacrylate/acrylic acid/3,4-epoxytricyclo[5.2.1,0^{2,6}]decan-8-yl acrylate/3,4-epoxytricyclo[5.2.1.0^{2,6}]decan-9-yl acrylate copolymer. This copolymer has a structural unit represented by the following formula.

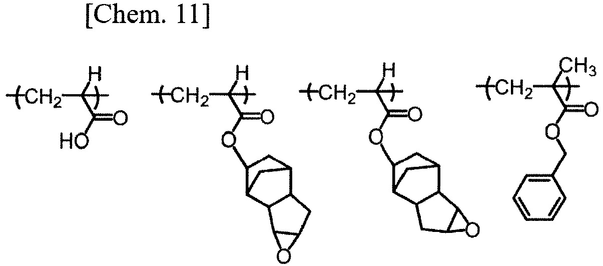

The resin [K4] may be, for example, a resin in which glycidyl methacrylate has been added to a tricyclodecyl methacrylate/benzyl methacrylate/methacrylic acid copolymer.

The polystyrene-equivalent weight-average molecular weight of the resin (B) is preferably 3000 to 100000, more preferably 5000 to 50000 and still more preferably 5000 to 30000. When the molecular weight is within the above-described ranges, there is a tendency that the hardness of an optical filter improves, the residual film rate is high, the solubility of an unexposed portion in developers is favorable, and the resolution of a coloring pattern improves.

The degree of dispersion [weight-average molecular weight (Mw)/number-average molecular weight (Mn)] of the resin (B) is preferably 1.1 to 6 and more preferably 1.2 to 4.

The acid value of the resin (B) is preferably 50 to 170 mg-KOH/g, more preferably 60 to 150 mg-KOH/g and still more preferably 70 to 135 mg-KOH/g, in terms of solid content. Here, the acid value is the amount (mg) of potassium hydroxide necessary to neutralize 1 g of the resin (B), and can be obtained, for example, by titration using a potassium hydroxide aqueous solution.

The content of the resin (B) may be, for example, 7 to 99 mass%, 53 to 99 mass%, 7 to 65 mass%, 13 to 60 mass% or 17 to 55 mass%, with respect to the total amount of the solid content in the resin composition. When the content of the resin (B) is within the above-described ranges, a coloring pattern can be favorably formed, and there is a tendency that the resolution and residual film rate of the coloring pattern improve.

### <Polymerizable Compound (C)>

The polymerizable compound (C) is a compound that can be polymerized with an active radical and/or acid generated from the polymerization initiator (D). The polymerizable compound (C) is, for example, a compound having a polymerizable ethylenic unsaturated bond and preferably a (meth)acrylic acid ester.

The polymerizable compound (C) is preferably a polymerizable compound having three or more ethylenically unsaturated bonds. Examples of such a polymerizable compound include trimethylolpropane tri(meth)acrylate, pentaerythritol tri(meth)acrylate, pentaerythritol tetra(meth)acrylate, dipentaerythritol poly(meth)acrylate (for example, dipentaerythritol penta(meth)acrylate, dipentaerythritol hexa(meth)acrylate and the like), tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, caprolactone-modified dipentaerythritol hexa(meth)acrylate and the like. Among these, trimethylolpropane tri(meth)acrylate, dipentaerythritol penta(meth)acrylate or dipentaerythritol hexa(meth)acrylate is preferable.

The weight-average molecular weight of the polymerizable compound (C) is preferably 150 or more and 2900 or less and more preferably 250 or more and 1500 or less.

The content of the polymerizable compound (C) is preferably 7 to 65 mass%, more preferably 13 to 60 mass% and still more preferably 17 to 55 mass%, with respect to the total amount of the solid content in the resin composition. When the content of the polymerizable compound (C) is within the above-described ranges, there is a tendency that the residual film rate at the time of forming a coloring pattern and the chemical resistance of an optical filter improve.

### <Polymerization initiator (D)>

The polymerization initiator (D) is not particularly limited as long as the polymerization initiator is a compound that generates an active radical, an acid or the like with light or heat and is capable of initiating polymerization, and known polymerization initiators can be used.

Examples of the polymerization initiator that generates an active radical include alkylphenone compounds, triazine compounds, acylphosphine oxide compounds, O-acyloxime compounds and biimidazole compounds.

The O-acyloxime compounds are compounds having a partial structure represented by a formula (d1). Hereinafter, * represents a bonding hand.

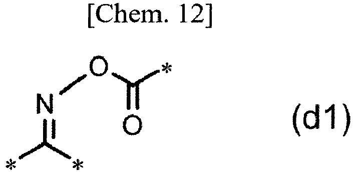

Examples of the O-acyloxime compounds include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazole-3-yl)ethane-1-imine, N-acetoxy-1-[9-ethyl-6-{2-methyl-4-(3,3-dimethyl-2,4-dioxacyclopenta nylmethyloxy)benzoyl}-9H-carbazole-3-yl]ethane-1 -imine, N-acetoxy-1-[9-ethyl-6-(2-methylbenzoyl)-9H-carbazole-3-yl)-3-cyclop entylpropane-1-imine, and N-benzoyloxy-1-[9-ethyl-6-(2-methylbenzoyl)-9H-carbazole-3-yl]-3-cy clopentylpropan-1-one-2-imine and N-acetyloxy-1-(4-phenylsulfanylphenyl)-3-cyclohexylpropan-1 -one-2-i mine. Commercially available products such as IRGACURE OXE01 and OXE02 (both manufactured by BASF Japan Ltd.) and N-1919 (manufactured by ADEKA Corporation) may also be used. Among these, from the viewpoint of obtaining a highly bright optical filter, the O-acyloxime compound is preferably at least one selected from the group consisting of N-acetyloxy-1-(4-phenylsulfanylphenyl)-3-cyclohexylpropan-1-one-2-i mine, N-benzoyloxy-1-(4-phenylsulfanylphenyl)butan-1-one-2-imine, N-benzoyloxy-1-(4-phenylsulfanylphenyl)octan-1 -one-2-imine and N-benzoyloxy-1 -(4-phenylsulfanylphenyl)-3 -cyclopentylpropan-1 -one-2-imine, and more preferably N-acetyloxy-1-(4-phenylsulfanylphenyl)-3-cyclohexylpropan-1-one-2-i mine or N-benzoyloxy-1-(4-phenylsulfanylphenyl)octan-1-one-2-imine.

The alkylphenone compounds are compounds having a partial structure represented by a formula (d2) or a partial structure represented by a formula (d3). In these partial structures, the benzene ring may have a substituent. From the viewpoint of sensitivity, compounds having a partial structure represented by the formula (d2) are preferable as the alkylphenone compounds.

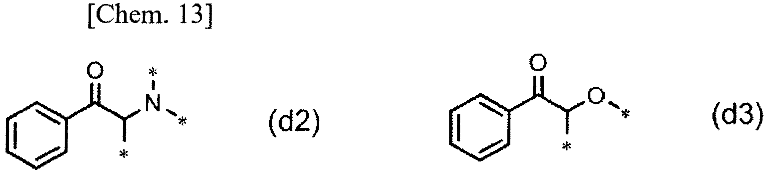

Examples of the compounds having a partial structure represented by the formula (d2) include 2-methyl-2-morpholino-1-(4-methylsulfanylphenyl)propan-1-one, 2-dimethylamino-1-(4-morpholinophenyl)-2-benzylbutan-1-one, 2-(dimethylamino)-2-[(4-methylphenyl)methyl]-1-[4-(4-morpholinyl)ph enyl]butan-1-one and the like. Commercially available products such as Omnirad (former IRGACURE) 369, 907 and 379 (all manufactured by IGM Resins B.V.) may also be used.

Examples of the compounds having a partial structure represented by the formula (d3) include oligomers of 2-hydroxy-2-methyl-1-phenylpropan-1-one, 2-hydroxy-2-methyl-1-[4-(2-hydroxyethoxy)phenyl]propan-1-one, 1 -hydroxycyclohexylphenyl ketone and 2-hydroxy-2-methyl-1-(4-isopropenylphenyl)propan-1-one, α,α-diethoxyacetophenone, benzyl dimethyl ketal and the like.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3 ,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazin e, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, 2,4-bis(trichloromethyl)-6-[2-(3,4-dimethoxyphenyl)ethenyl)-1,3,5-triaz ine and the like.

Examples of the acylphosphine oxide compounds include 2,4,6-trimethylbenzoyldiphenylphosphine oxide and the like. Commercially available products such as Omnirad 819 (manufactured by IGM Resins B.V.) may also be used.

Examples of the biimidazole compounds include 2,2' -bis(2-chlorophenyl)-4,4 ',5,5' -tetraphenylbiimidazole, 2,2'-bis(2,3-dichlorophenyl)-4,4',5,5'-tetraphenylbiimidazole (for example, refer to Japanese Unexamined Patent Application Publication No. 6-75372, Japanese Unexamined Patent Publication No. 6-75373 and the like), 2,2'-bis(2-chlorophenyl)-4,4',5,5'-tetraphenyl biimidazole, 2,2' -bis(2-chlorophenyl)-4,4 ',5,5' -tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, refer to Japanese Examined Patent Application Publication No. 48-38403, Japanese Unexamined Patent Application Publication No. 62-174204 and the like) and an biimidazole compound in which phenyl groups at the 4,4',5,5' positions are substituted with a carboalkoxy groups (for example, refer to Japanese Unexamined Patent Application Publication No. 7-10913 and the like).

Further examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone and 2,4,6-trimethylbenzophenone; quinone compounds such as 9,10-phenanthrene quinone, 2-ethylanthraquinone, and camphorquinone; 10-butyl-2-chloroacridone; benzyl; methyl phenylglyoxylate; titanocene compounds; and the like. These are preferably used in combination with a polymerization initiation aid (D1) (particularly, an amine compound) described below.

Examples of the polymerization initiator that generates an acid include onium salts such as 4-hydroxyphenyldimethylsulfonium p-toluenesulfonate, 4-hydroxyphenyldimethylsulfonium hexafluoroantimonate, 4-acetoxyphenyldimethylsulfonium p-toluenesulfonate, 4-acetoxyphenylmethylbenzylsulfonium hexafluoroantimonate, triphenylsulfonium p-toluenesulfonate, triphenylsulfonium hexafluoroantimonate, diphenyliodonium p-toluenesulfonate and diphenyliodonium hexafluoroantimonate, nitrobenzyl tosylates, benzoin tosylates and the like.

The polymerization initiator (D) is preferably a polymerization initiator that generates an active radical, more preferably a polymerization initiator containing at least one selected from the group consisting of an alkylphenone compound, a triazine compound, an acylphosphine oxide compound, an O-acyloxime compound and a biimidazole compound, and still more preferably a polymerization initiator containing an O-acyloxime compound.

The content of the polymerization initiator (D) may be, for example, 0.1 to 30 parts by mass or 1 to 20 parts by mass with respect to 100 parts by mass of the total amount of the resin (B) and the polymerizable compound (C). When the content of the polymerization initiator (D) is within the above-described ranges, since there is a tendency that the sensitivity increases and the exposure time is shortened, the productivity of an optical filter improves.

### <Polymerization Initiation Aid (D1)>

The resin composition may further contain a polymerization initiation aid (D1). The polymerization initiation aid (D1) is a compound that is used to promote the polymerization of the polymerizable compound (C) whose polymerization has been initiated by the polymerization initiator, or a sensitizer. The polymerization initiation aid (D1) is usually used in combination with the polymerization initiator (D). Examples of the polymerization initiation aid (D1) include amine compounds, alkoxy anthracene compounds, thioxanthone compounds and carboxylic acid compounds.

Examples of the amine compounds include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone,4,4'-bis(ethylmethylamino)benzop henone and the like, and among these, 4,4'-bis(diethylamino)benzophenone is preferable. Commercially available products such as EAB-F (manufactured by Hodogaya Chemical Co., Ltd.) may also be used.

Examples of the alkoxy anthracene compounds include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene and 2-ethyl-9,10-dibutoxyanthracene.

Examples of the thioxanthone compounds include 2-isopropylthioxanthone, 4-isopropylthioxanthone, 2,4-diethylthioxanthone, 2,4-dichlorothioxanthone and 1-chloro-4-propoxythioxanthone.

Examples of the carboxylic acid compounds include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

In a case of using these polymerization initiation aids (D1), the content thereof is preferably 0.1 to 30 parts by mass and more preferably 1 to 20 parts by mass with respect to 100 parts by mass of the total amount of the resin (B) and the polymerizable compound (C). When the amount of the polymerization initiation aid (D1) is within this range, it is possible to form a coloring pattern at a higher sensitivity, and the productivity of an optical filter tends to improve.

### <Solvent (E)>

The solvent (E) is not particularly limited, and it is possible to use solvents that are commonly used in the field. Examples of the solvent (E) include an ester solvent (that is, a solvent that contains -COO- but does not contain -O- in the molecule), an ether solvent (that is, a solvent that contains -O- but does not contain-COO- in the molecule), an ether ester solvent (that is, a solvent that contains -COO- and-O- in the molecule), a ketone solvent (that is, a solvent that contains -CO- but does not contain -COO- in the molecule), an alcohol solvent (a solvent that contains OH but does not contain -O-, -CO- and -COO- in the molecule), an aromatic hydrocarbon solvent, an amide solvent, dimethyl sulfoxide and the like.

Examples of the ester solvent include methyl lactate, ethyl lactate, butyl lactate, methyl 2-hydroxyisobutyrate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, γ-butyrolactone and the like.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, methyl anisole and the like.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-methoxybutyl acetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, diethylene glycol monobutyl ether acetate and the like.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, isophorone and the like.

Examples of the alcohol solvent include methanol, ethanol, propanol, butanol, hexanol, cyclohexanol, ethylene glycol, propylene glycol, glycerin and the like.

Examples of the aromatic hydrocarbon solvent include benzene, toluene, xylene, mesitylene and the like.

Examples of the amide solvent include N,N-dimethylformamide, N,N-dimethylacetamide, N-methylpyrrolidone and the like.

The solvent preferably contains one or more selected from the group consisting of an ether solvent, an ether ester solvent and an amide solvent, more preferably contains an ether solvent, an ether ester solvent and an amide solvent, and still more preferably contains diethylene glycol methyl ethyl ether, propylene glycol monomethyl ether acetate and N-methylpyrrolidone.

The content of the solvent (E) may be, for example, 67 to 95 mass%, 70 to 95 mass% or 75 to 92 mass%, with respect to the total amount of the resin composition. In other words, the solid content of the resin composition may be, for example, 5 to 33 mass%, 5 to 30 mass% or 8 to 25 mass%. When the content of the solvent (E) is within the above-described ranges, since flatness at the time of application becomes favorable, there is a tendency that the display characteristic becomes favorable.

### <Leveling Agent (F)>

Examples of the leveling agent (F) include a silicone-based surfactant, a fluorine-based surfactant, and the like. These surfactants may have a polymerizable group at a side chain.

Examples of the silicone-based surfactant include surfactants having a siloxane bond in the molecule. Specific examples of the silicone-based surfactant include DOWSIL (registered trademark) (former TORAY SILICONE) DC3PA, SH7PA, DC11PA, SH21PA, SH28PA, SH29PA, SH30PA and SH8400 (product names, manufactured by DuPont Toray Specialty Materials K.K. (former Dow Coming Toray Co., Ltd.)); KP321, KP322, KP323, KP324, KP326, KP340 and KP341 (manufactured by Shin-Etsu Chemical Co., Ltd.); TSF400, TSF401, TSF410, TSF4300, TSF4440, TSF4445, TSF4446, TSF4452 and TSF4460 (manufactured by Momentive Performance Materials Japan LLC.); and the like.

Alternatively, the silicone-based surfactant may be a silicone-based surfactant having a fluorine atom. Examples of the silicone-based surfactant having a fluorine atom include surfactants having a siloxane bond and a fluorocarbon chain in the molecule. Specific examples of the silicone-based surfactant include MEGAFACE (registered trademark) R08, BL20, F475, F477 and F443 (manufactured by DIC Corporation) and the like.

Examples of the fluorine-based surfactant include surfactants having a fluorocarbon chain in the molecule. Specific examples of the fluorine-based surfactant include FLUORAD (registered trademark) FC430 and FC431 (manufactured by Sumitomo 3M Limited); MEGAFACE (registered trademark) F142D, F171, F172, F173, F177, F183, F554, R30 and RS-718-K (manufactured by DIC Corporation); EFTOP (registered trademark) EF301, EF303, EF351 and EF352 (manufactured by Mitsubishi Materials Electronic Chemicals Co., Ltd.); SURFLON (registered trademark) S381, S382, SC101 and SC105 (manufactured by AGC Inc. (former Asahi Glass Co., Ltd.)); E5844 (manufactured by Daikin Fine Chemical Laboratory); and the like.

The content of the leveling agent (F) may be, for example, 0.001 mass% or more and 0.2 mass% or less, 0.002 mass% or more and 0.1 mass% or less, or 0.01 mass% or more and 0.05 mass% or less, with respect to the total amount of the resin composition, from the viewpoint of obtaining an optical filter having favorable flatness. Note that this content does not include the content of the pigment dispersant.

### <Other Components>

The resin composition according to the present aspect may contain, as necessary, an additive that is known in the technical field, such as a filler, other polymer compounds, an adhesion promoter, an antioxidant, a light stabilizer or a chain transfer agent.

As described below, the resin composition according to the present aspect may be for near-infrared cut filters or near-infrared transmission filters.

### < Manufacturing Method of Resin Composition>

The resin composition according to the present aspect can be prepared by, for example, mixing the coloring agent (A) and the resin (B), and the polymerizable compound (C), the polymerization initiator (D), the solvent (E), the leveling agent (F), the polymerization initiation aid (D1) and other components, which are used as necessary. The resin composition after the mixing is preferably filtered with a filter having a pore diameter of approximately 0.01 to 10 µm.

### <Optical Filter and Manufacturing Method thereof>

An optical filter according to an aspect of the present invention contains a cured product of the above-described resin composition. The optical filter may consist of a cured product of the above-described resin composition. The cured product of the above-described resin composition absorbs a specific wavelength in the near-infrared region while sufficiently transmitting visible light, and thus the optical filter according to the present aspect can be used as, for example, a near-infrared cut filter. In addition, the cured product of the above-described resin composition can be used as a near-infrared transmission filter for transmitting a specific wavelength in the near-infrared region. Therefore, the optical filter according to the present aspect can be used in, for example, infrared sensors and display devices (for example, liquid crystal display devices, organic EL devices, or electronic paper).

The cured product of the resin composition can be obtained by, for example, irradiating the resin composition with light or heating the resin composition.

The optical filter containing the compound represented by the formula (I), the formula (II), the formula (III) or the formula (IV) as the coloring agent (A) has the absorption maximum at preferably 700 nm to 2500 nm, more preferably 700 nm to 1500 nm and still more preferably 700 nm to 1300 nm. The optical filter containing the compound represented by the formula (I) may have the absorption maximum at, for example, 720 to 820 nm or 760 to 780 nm. The optical filter containing the compound represented by the formula (II) may have the absorption maximum at, for example, 700 to 760 nm or 700 to 720 nm. The optical filter containing the compound represented by the formula (III) may have the absorption maximum at, for example, 730 to 890 nm, 780 to 840 nm, 730 to 950 nm or 770 to 830 nm. The optical filter containing the compound represented by the formula (IV) may have the absorption maximum at, for example, 965 to 1065 nm or 980 to 1050 nm.

The thickness of the optical filter is preferably 20 µm or less, more preferably 6 µm or less, still more preferably 3 µm or less, far still more preferably 1.5 µm or less and particularly preferably 0.5 µm or less. The thickness of the optical filter is preferably 0.1 µm or more, more, preferably 0.2 µm or more and still more preferably 0.3 µm or more. The thickness of the optical filter may be, for example, 0.1 to 30 µm, 0.1 to 20 µm or 0.5 to 6 µm.

A method for manufacturing the optical filter is not particularly limited, and the optical filter can be manufactured by a conventionally known method. For example, the optical filter can be formed on an arbitrary substrate by a photolithography method, an inkjet method or a printing method. Among these, the photolithography method is preferable.

The substrate may be, for example, a glass plate of quartz glass, borosilicate glass, alumina silicate glass, soda lime glass in which a surface is coated with silica or the like, a resin plate of polycarbonate, polymethyl methacrylate, polyethylene terephthalate or the like, or silicon. In addition, it is also possible to use substrates including a thin film of aluminum, silver, a silver/copper/palladium alloy or the like on these substrates. It is also possible to use substrates in which a hexamethyldisilazane (HMDS) treatment has been performed on a silicon substrate. Furthermore, it is also possible to use substrates including another optical filter, a resin layer, a transistor, a circuit or the like on these substrates.

In the photolithography method, first, the above-described resin composition is applied to the substrate and the resin composition is dried to form a layer of the resin composition. The application of the resin composition can be performed by, for example, a spin coating method, a slit coating method or a slit and spin coating method. The thickness of the layer of the resin composition can be determined as appropriate depending on the target thickness of the optical filter. The drying of the resin composition can be performed by, for example, heat drying (prebaking) and/or reduced-pressure drying. The temperature of the heat drying is preferably 30°C to 120°C and more preferably 50°C to 110°C. The heating time is preferably 10 seconds to 60 minutes and more preferably 30 seconds to 30 minutes. The reduced-pressure drying is preferably performed at a pressure of 50 to 150 Pa within a temperature range of 20°C to 25°C.

After that, the resin composition layer is exposed through a photomask having a predetermined pattern and then brought into contact with a developer to be developed, thereby forming a coloring pattern made of the cured product of the resin composition. The pattern of the photomask can be determined as appropriate depending on the use of the optical filter. A light source that is used for exposure is preferably a light source that generates light of a wavelength of 250 to 450 nm. Light of such a wavelength can be obtained by, for example, cutting light of a specific wavelength range (for example, shorter than 350 nm) from a predetermined light source using a filter that cut this wavelength range, or can also be obtained by selectively extracting light having a specific wavelength (for example, near 436 nm, near 408 nm or near 365 nm) using bandpass filters that extracts these wavelength ranges. The light source may be, for example, a mercury lamp, a light-emitting diode, a metal halide lamp or a halogen lamp. It is preferable to use a reduced projection exposure device or proximity exposure device such as a mask aligner and a stepper, since it is possible to uniformly irradiate the entire exposure surface with parallel light rays and to accurately align the photomask and the substrate.

The developer is preferably, for example, an aqueous solution of an alkaline compound such as potassium hydroxide, sodium hydrogen carbonate, sodium carbonate or tetramethylammonium hydroxide. The concentration of the alkaline compound in the aqueous solution is preferably 0.01 to 10 mass% and more preferably 0.03 to 5 mass%. The developer may contain a surfactant. The development can be performed by, for example, a paddle method, a dipping method or a spray method. The substrate may be tilted at an arbitrary angle during the development. By the development, an unexposed portion of the layer of the resin composition is dissolved in the developer and removed.

It is preferable to perform post baking on the obtained coloring pattern. The post baking temperature may be, for example, 80°C to 250°C, 100°C to 245°C, 150°C to 250°C or 160°C to 250°C. The post baking time may be, for example, 1 to 120 minutes, 2 to 30 minutes or 5 to 60 minutes.

Note that in the photolithography method, it is possible to obtain a cured product of the resin composition that is not patterned, by not using a photomask during the exposure and/or not developing.

The cured product of the resin composition and the coloring pattern are both encompassed in the scope of the optical filter according to the present aspect.

### <Solid State Image Sensor>

A solid state image sensor according to an aspect of the present invention includes the above-described optical filter. The optical filter may be a near-infrared transmission filter and/or a near-infrared cut filter. Portions except for the optical filter in the solid state sensor may be the same as the conventionally known solid state image sensors. FIG. 1 shows an example of the solid state image sensor.

A solid state image sensor 100 shown in FIG. 1 includes a semiconductor substrate 2 including a light-receiving device or the like (not shown), near-infrared cut filters 4, near-infrared transmission filters 6, color filters 8, micro lenses 10 and a flattening layer 12. As the near-infrared cut filters 4 and the near-infrared transmission filters 6, the above-described optical filters can be used. The color filter 8 is not particularly limited, and it is possible to use conventionally known color filters for pixel formation such as a color filter described in Japanese Unexamined Patent Application Publication No. 2014-043556. The micro lenses 10 and the flattening layer 12 are also not particularly limited, and known micro lenses and flattening layers can be used.

Note that in the solid state image sensor 100 shown in FIG. 1, the near-infrared cut filters 4, the color filters 8 and the micro lenses 10 are laminated in this order, but the positions of the near-infrared cut filters 4 and the color filters 8 may be exchanged. In addition, an additional other layer may be provided between the near-infrared cut filters 4 and the color filters 8.

The solid state image sensor according to the present aspect can be used in, for example, infrared sensor and display devices (for example, liquid crystal display devices, organic EL devices, or electronic paper). That is, according to an aspect of the present invention, an infrared sensor and a display device including the above-described solid state image sensor are also provided.

### Examples

### <Synthesis Example 1>

A coloring agent (A1-1) which is a compound represented by the formula (II) was synthesized. The coloring agent (A1-1) is the compound 2c described in Furuyama, T., Shimasaki, F., Saikawa, N. et al., "One-step synthesis of ball-shaped metal complexes with a main absorption band in the near-IR region", Scientific Reports 2019, 9, 16528, DOI: 10.1038/s41598-019-53014-7, and was synthesized by the method described in the article.

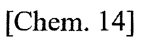

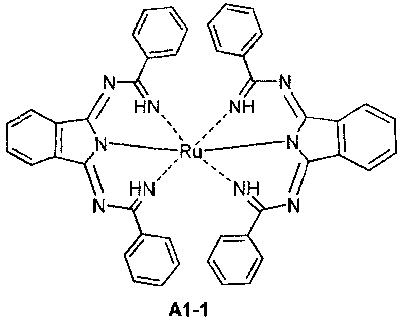

### <Synthesis Example 2>

A coloring agent (A1-2) which is a compound represented by the formula (I) was synthesized. The coloring agent (A1-2) is the compound 1a described in Furuyama, T., Shimasaki, F., Saikawa, N. et al., "One-step synthesis of ball-shaped metal complexes with a main absorption band in the near-IR region", Scientific Reports 2019, 9, 16528, DOI: 10.1038/s41598-019-53014-7, and was synthesized by the method described in the article.

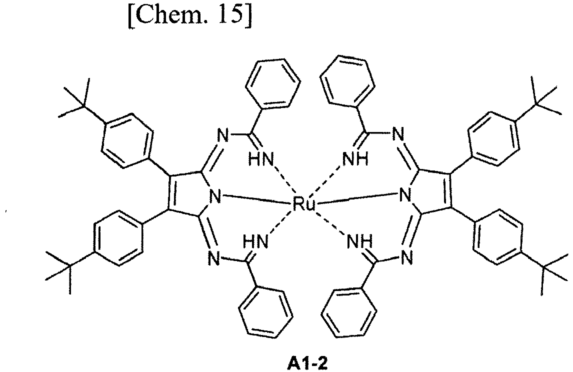

### <Synthesis Example 3>

A coloring agent (A1-3) which is a compound represented by the formula (IV) was synthesized. The coloring agent (A1-3) is the compound 4a described in Nagao Kobayashi, Taniyuki Furuyama, and Koh Satoh, "Rationally Designed Phthalocyanines Having Their Main Absorption Band beyond 1000 nm", Journal of the American Chemical Society, 2011 133, 49, 19642-19645, DOI: 10.1021/ja208481q, and was synthesized by the method described in the article.

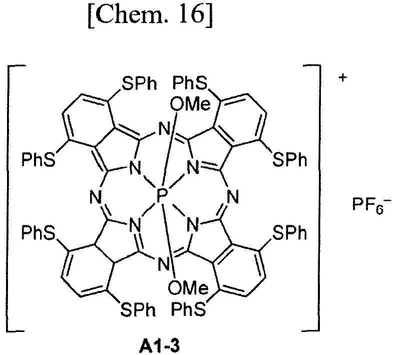

### <Synthesis Example 4>

A coloring agent (A1-4) which is a compound represented by the formula (III) was synthesized. The coloring agent (A1-4) is the compound 3 described in Taniyuki Furuyama, Takashi Ishii, Naoya Ieda, Hajime Maeda, and Masahito Segi, "Cationic axial ligands on sulfur substituted silicon (iv) phthalocyanines: improved hydrophilicity and exceptionally red-shifted absorption into the NIR region", Chemical Communications, 2019, 55, 7311-7314, DOI: 10.1039/C9CC03022K and, was synthesized by the method described in the article.

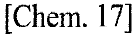

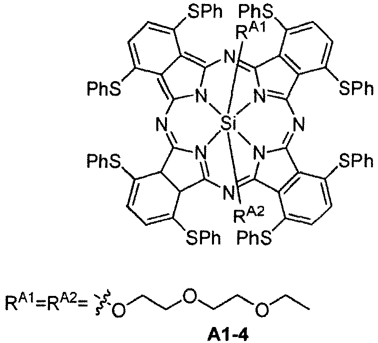

### <Synthesis Example 5>

A coloring agent (A1-5) which is a compound represented by the formula (III) was synthesized. The coloring agent (A1-5) is the compound 4Q described in Taniyuki Furuyama, Takashi Ishii, Naoya Ieda, Hajime Maeda, and Masahito Segi, "Cationic axial ligands on sulfur substituted silicon (iv) phthalocyanines: improved hydrophilicity and exceptionally red-shifted absorption into the NIR region", Chemical Communications, 2019, 55, 7311-7314, DOI: 10.1039/C9CC03022K, and was synthesized by the method described in the article.

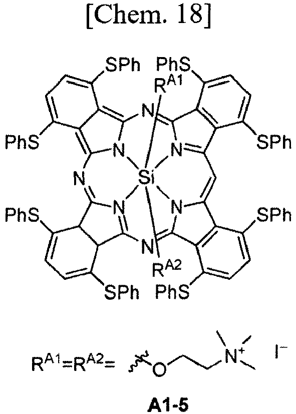

### <Synthesis Example 6>

A coloring agent (A1-6) which is a compound represented by the formula (III) was synthesized. The coloring agent (A1-6) is the compound 2 described in Taniyuki Furuyama, Takashi Ishii, Naoya Ieda, Hajime Maeda, and Masahito Segi, "Cationic axial ligands on sulfur substituted silicon (iv) phthalocyanines: improved hydrophilicity and exceptionally red-shifted absorption into the NIR region", Chemical Communications, 2019, 55, 7311-7314, DOI: 10.1039/C9CC03022K, and was synthesized by the method described in the article.

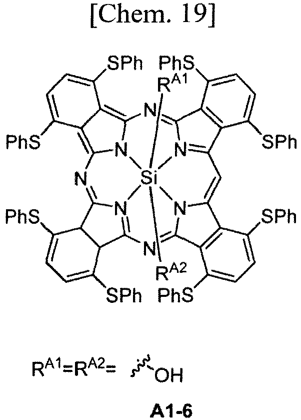

### <Synthesis Example 7>

A resin (B-1) was synthesized as described below. First, into a flask including a reflux condenser, a dropping funnel and a stirrer, an appropriate amount of nitrogen was let to flow to substitute the inside with a nitrogen atmosphere, and 340 parts of propylene glycol monomethyl ether acetate was added and heated up to 80°C under stirring. Next, a solution mixture of 57 parts by mass of acrylic acid, 54 parts by mass of a mixture of 3,4-epoxytricyclo[5.2.1.0^{2,6}]decan-8-yl acrylate and 3,4-epoxytricyclo[5.2.1.0^{2,6}]decan-9-yl acrylate (the content ratio was 1:1 in terms of mole ratio), 239 parts by mass of benzyl methacrylate and 73 parts by mass of propylene glycol monomethyl ether acetate was added dropwise for five hours. Meanwhile, a solution in which 40 parts by mass of a polymerization initiator 2,2-azobis(2,4-dimethylvaleronitrile) is dissolved in 197 parts by mass of propylene glycol monomethyl ether acetate was added dropwise for six hours. After the dropwise addition of the initiator solution was finished, it was held at 80°C for three hours and then cooled to room temperature, thereby obtaining a copolymer (resin (B-1)) solution with a viscosity measured with a B-type viscometer (23°C) of 127 mPas and a solid content of 37.0 weight%. A weight-average molecular weight Mw of the generated copolymer was 9.4 × 10³, a degree of dispersion was 1.89, and an acid value in terms of solid content was 114 mg-KOH/g. The resin (B-1) has the following structural units.

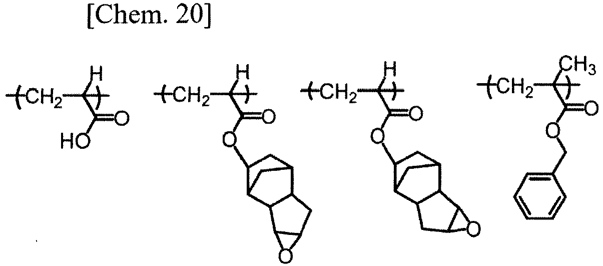

### <Synthesis Example 8>

A resin (B-2) was synthesized as described below. First, 100 parts by mass of propylene glycol monomethyl ether acetate was put into a flask including a stirring device, a dropping funnel, a condenser, a thermometer and a gas introduction pipe, stirred under nitrogen substitution, and heated to 120°C. Next, to a monomer mixture consisting of 7 parts by mass of tricyclodecyl methacrylate, 27 parts by mass of benzyl methacrylate and 13 parts by mass of methacrylic acid, 1 part by mass of PERBUTYL (registered trademark) O (manufactured by NOF Corporation) was added with respect to 100 parts by mass of the monomer mixture. This was added dropwise to the flask from the dropping funnel for two hours and further stirred at 120°C for two hours, thereby obtaining a copolymer. Next, the inside of the flask was substituted with an air, and 7 parts by mass of glycidyl methacrylate, 0.34 parts by mass of triphenylphosphine and 0.07 parts by mass of methylhydroquinone were added to a solution of the above-described copolymer and continuously reacted at 120°C. The reaction was ended when the acid value in terms of solid content reached 105 mg-KOH/g, and 32 parts by mass of propylene glycol monomethyl ether acetate was added thereto, thereby obtaining a solution of an alkaline-developable photosensitive resin (resin (B-2)) (Mw: 30000) with a solid content of 30%.

### <Test Example 1>

### (Example 1)

### [Preparation of Resin Composition]

The following components were mixed to obtain a resin composition 1.

| | |
|---|---|
| Coloring agent (A): Coloring agent (A1-1) | 0.015 parts by mass |
| Resin (B): Resin (B-1) | 1.5 parts by mass (in terms of solid content) |
| Solvent (E): Propylene glycol monomethyl ether acetate | |
| | 2.6 parts by mass |
| Solvent (E): N-methylpyrrolidone | 5.9 parts by mass |
| Leveling agent (F): Polyether-modified silicon oil (DOWSILSH 8400: manufactured by DuPont Toray Specialty Materials K.K.) | 0.00015 parts by mass |

### (Examples 2 to 5 and Comparative Example 1)

### [Preparation of Resin Composition]

Resin compositions 2 to 5 and a resin composition of Comparative Example 1 were obtained by the same method as Example 1 except that the coloring agent (A) in Example 1 was changed to the same amount (0.015 parts by mass) of the following compounds.
Example 2: Coloring agent (A1-2)
Example 3: Coloring agent (A1-3)
Example 4: Coloring agent (A1-4)
Example 5: Coloring agent (A1-5)

### Comparative Example 1: 4,5-Octakis(2,5-dichlorophenoxy)-3,6-{tetrakis(2,6-dimethyphenoxy)-te trakis(benzylamino) } oxyvanadium phthalocyanine

### [Formation of Coating Film]

Onto a 5 cm × 5 cm glass substrate (EAGLE 2000; manufactured by Corning Incorporated), the resin composition prepared in Examples 1 to 5 and Comparative Example 1 was applied by a spin coating method and then baked at 100°C for three minutes, thereby obtaining a coating film with a thickness of 1.0 µm. The thickness of the coating film was measured using a film thickness-measuring instrument (DEKTAK3: manufactured by Japan Vacuum Engineering Co., Ltd.).

### [Optical Characteristics]

The average values of the transmittances of the obtained coating films at 450 nm to 650 nm are shown in Table 1.

**[Table 1]**

| | Average value of transmittances at 450 nm to 650 nm |
|---|---|
| Example 1 | 99.0 |
| Example 2 | 98.3 |
| Example 3 | 98.5 |
| Example 4 | 98.0 |
| Example 5 | 98.3 |
| Comparative Example 1 | 98.0 |

### [Heat Resistance]

After that, a heat resistance test was performed on the obtained coating films at 120°C for 10 minutes. The transmittances of the coating films before and after the heat resistance test were measured, and the increase rates of the transmittances (that is, decrease rates of absorption rates) of maximum absorption wavelengths present within the wavelength ranges shown in Table 2 were calculated. The results are shown in Table 2. Note that the increase rate of the transmittance is a value obtained by subtracting the transmittance before the heat resistance test from the transmittance after the heat resistance test.

**[Table 2]**

| | Wavelength (nm) | Increase rate of transmittance |
|---|---|---|
| Example 1 | 700 to 720 | 1.1 |
| Example 2 | 760 to 780 | 0.3 |
| Example 4 | 780 to 840 | 0.6 |
| Example 5 | 770 to 830 | 1.0 |
| Comparative Example 1 | 880 to 900 | 1.5 |

### [Light Resistance]

An ultraviolet cut filter (COLORED OPTICAL GLASS L38; manufactured by HOYA Corporation; cuts light of 380 nm or shorter) was placed on the coating film obtained by three-minute baking at 100°C. A light resistance test in which irradiation with xenon lamp light was performed for 48 hours using a light resistance tester (SUNTEST CPS+: manufactured by Toyo Seiki Seisaku-sho, Ltd.) was performed, and the transmittances of the coating film before and after the light resistance test were measured. The increase rates of the transmittances of maximum absorption wavelengths present within the wavelength ranges shown in Table 3 are shown together in Table 3. Note that the increase rate of the transmittance is a value obtained by subtracting the transmittance before the light resistance test from the transmittance after the light resistance test.

**[Table 3]**

| | Wavelength (nm) | Increase rate of transmittance |
|---|---|---|
| Example 2 | 760 to 780 | 0.7 |
| Comparative Example 1 | 880 to 900 | 1.5 |

### <Test Example 2>

### (Example 6)

### [Preparation of Resin Composition]

The following components were mixed to obtain a resin composition 6.

| | |
|---|---|
| Coloring agent (A): Coloring agent (A1-1) | 0.015 parts by mass |
| Resin (B): Resin (B-2) | 0.81 parts by mass (in terms of solid content) |
| Polymerizable compound (C): Dipentaerythritol polyacrylate (NK ESTER A-9550 manufactured by Shin-Nakamura Chemical Co., Ltd.) | 0.54 parts by mass (in terms of solid content) |
| Polymerization initiator (D): 2-Methyl-2-morpholino-1-(4-methylsulfanylphenyl)propan-1-one (Omnirad 907 manufactured by IGM Resins B.V.) | 0.14 parts by mass |
| Solvent (E): Propylene glycol monomethyl ether acetate | 2.0 parts by mass |
| Solvent (E): N-methylpyrrolidone | 6.5 parts by mass |

### (Example 7 and Comparative Example 2)

### [Preparation of Resin Composition]

A resin composition 7 and a resin composition of Comparative Example 2 were obtained by the same method as Example 6 except that the coloring agent (A) in Example 6 was changed to the same amount (0.015 parts by mass) of the following compounds.

### Example 7: Coloring agent (Al-4)

### Comparative Example 2: 4,5-Octakis(2,5-dichlorophenoxy)-3,6- {tetrakis(2,6-dimethyphenoxy)-te trakis(benzylamino)}oxyvanadium phthalocyanine

### [Formation of Coating Film]

Onto a 5 cm × 5 cm glass substrate (EAGLE 2000; manufactured by Corning Incorporated), the colored resin composition prepared in Example 6 and Comparative Example 2 was applied by a spin coating method and then baked at 100°C for three minutes, thereby obtaining a coating film with a thickness of 1.0 µm.

### [Heat Resistance]

After that, a heat resistance test was performed on the obtained coating films at 120°C for 10 minutes, and the transmittances of the coating films before and after the heat resistance test were measured. The increase rates of the transmittances of maximum absorption wavelengths present within the wavelength ranges shown in Table 4 are shown together in Table 4.

**[Table 4]**

| | Wavelength (nm) | Increase rate of transmittance |
|---|---|---|
| Example 6 | 700 to 720 | 0.02 |
| Example 7 | 780 to 840 | 0.90 |
| Comparative Example 2 | 880 to 900 | 2.4 |

### [Light Resistance]

An ultraviolet cut filter (COLORED OPTICAL GLASS L38; manufactured by HOYA Corporation; cuts light of 380 nm or shorter) was placed on the coating film obtained by three-minute baking at 100°C. A light resistance test in which irradiation with xenon lamp light was performed for 48 hours using a light resistance tester (SUNTEST CPS+: manufactured by Toyo Seiki Seisaku-sho, Ltd.) was performed, and the transmittances of the coating film before and after the light resistance test were measured. The increase rates of the transmittances of maximum absorption wavelengths present within the wavelength ranges shown in Table 5 are shown together in Table 5.

**[Table 5]**

| | Wavelength (nm) | Increase rate of transmittance |
|---|---|---|
| Example 6 | 700 to 720 | 4.8 |
| Comparative Example 2 | 880 to 900 | 5.5 |

### <Test Example 3>

The same resin compositions as in Test Example 1 and Test Example 2 were prepared using the coloring agent (A1-6) as the coloring agent (A), and coating films were formed. As a result of performing the heat resistance test and the light resistance test under the same conditions as Test Example 1 and Test Example 2, the increase rate of the transmittance of maximum absorption wavelength present in a wavelength range of 730 to 950 nm was low compared with the increase rate of the transmittance in the comparative example.

### Reference Signs List

2···Semiconductor substrate, 4···Near-infrared cut filter, 6··· Near-infrared transmission filter, 8···Color filter, 10···Micro lens, 100···Solid state image sensor.

## Claims

1. A resin composition comprising:
a coloring agent; and
a resin,
wherein the coloring agent comprises a compound represented by a formula (I), a formula (II), a formula (III) or a formula (IV), 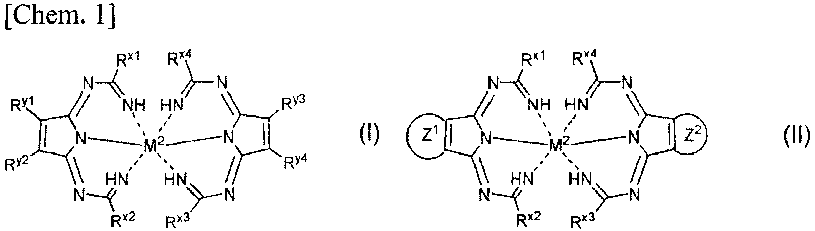
[wherein in the formula (I) and the formula (II),
R^{x1} to R^{x4} each independently represent a chain hydrocarbon group having 1 to 20 carbon atoms, an aryl group having 6 to 20 carbon atoms or a heteroaryl group having 2 to 20 carbon atoms,
-CH₂- contained in the chain hydrocarbon group is optionally substituted with -O-,
a hydrogen atom contained in the chain hydrocarbon group is optionally substituted with a halogen atom,
hydrogen atoms contained in the aryl group and the heteroaryl group are each independently optionally substituted with a halogen atom, -OR¹, -SR¹ or -NR²R³,
R¹ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR²- or -N⁺(R²R³)X⁻-, and hydrogen atoms contained in the aryl group and the heteroaryl group are each independently optionally substituted with a halogen atom or a straight chain or branched chain alkoxy group having 1 to 20 carbon atoms,
R² and R³ each independently represent a hydrogen atom or a chain hydrocarbon group having 1 to 10 carbon atoms, wherein -CH₂-contained in the hydrocarbon group is optionally substituted with -O-, or
R² and R³ bond to each other to form a ring,
X represents a halogen atom, PF₆, ClO₄ or BF₄,
R^{y1} to R^{y4} in the formula (I) each independently represent a chain hydrocarbon group having 1 to 20 carbon atoms, an aryl group having 6 to 20 carbon atoms or a heteroaryl group having 2 to 20 carbon atoms,
-CH₂- contained in the chain hydrocarbon group is optionally substituted with -O-,
a hydrogen atom contained in the chain hydrocarbon group is optionally substituted with a halogen atom,
hydrogen atoms contained in the aryl group and the heteroaryl group are each independently optionally substituted with a halogen atom, -OR¹, -SR¹ or -NR²R³,
a ring Z¹ and a ring Z² in the formula (II) each independently represent an aromatic hydrocarbon ring having 6 to 20 carbon atoms or a heteroaromatic ring having 2 to 20 carbon atoms,
hydrogen atoms contained in the aromatic hydrocarbon ring and the heteroaromatic ring are optionally substituted with a halogen atom, a chain hydrocarbon group having 1 to 20 carbon atoms, -OR¹, -SR¹ or -NR²R³,
when a plurality of R's, R²s or R³s is present, these may be the same as or different from each other, and
M² represents a divalent metal atom] 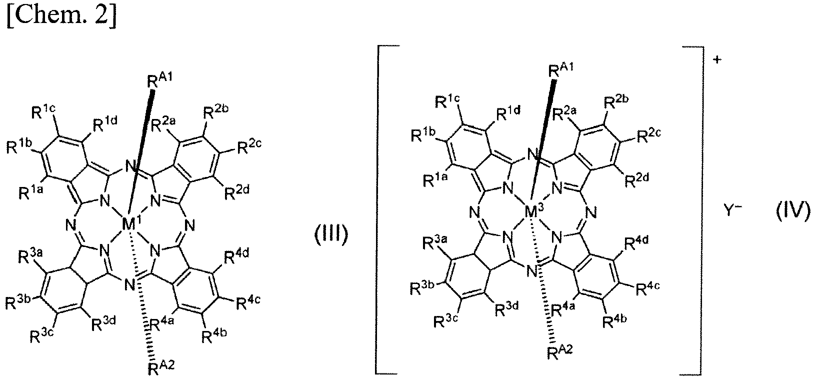
[wherein in the formula (III) and the formula (IV),
R^{1a} to R^{1d}, R^{2a} to R^{2d}, R^{3a} to R^{3d} and R^{4a} to R^{4d} each independently represent a hydrogen atom, a halogen atom, a chain hydrocarbon group having 1 to 20 carbon atoms, -OR¹, -SR¹ or -NR²R³, wherein at least one of R^{1a} to R^{1d}, R^{2a} to R^{2d}, R^{3a} to R^{3d} and R^{4a} to R^{4a} represents -SR¹,
R¹ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR²- or -N⁺(R²R³)X⁻-, and hydrogen atoms contained in the aryl group and the heteroaryl group are each independently optionally substituted with a halogen atom or a straight chain or branched chain alkoxy group having 1 to 20 carbon atoms,
R² and R³ each independently represent a hydrogen atom or a chain hydrocarbon group having 1 to 10 carbon atoms, wherein -CH₂-contained in the hydrocarbon group is optionally substituted with -O-, or
R² and R³ bond to each other to form a ring,
X represents a halogen atom, PF₆, ClO₄ or BF₄,
R^{A1} and R^{A2} each independently represent -OR⁴,
R⁴ represents a hydrogen atom, a chain hydrocarbon group having 1 to 10 carbon atoms, an aryl group having 6 to 20 carbon atoms or a heteroaryl group having 2 to 20 carbon atoms, wherein -CH₂-contained in the chain hydrocarbon group is optionally substituted with -O-, -NR⁵- or -N⁺(R⁵R⁶)X⁻-,
R⁵ and R⁶ each independently represent a hydrogen atom or a chain hydrocarbon group having 1 to 10 carbon atoms,
when a plurality of R's, R²s, R³s, R⁵s or R⁶s is present, these may be the same as or different from each other,
M¹ in the formula (III) represents a tetravalent metal atom or a non-metal atom,
M³ in the formula (IV) represents a pentavalent metal atom or a non-metal atom, and
Y⁻ in the formula (IV) represents a monovalent anion].

2. The resin composition according to Claim 1, further comprising:
a polymerizable compound; and
a polymerization initiator.

3. The resin composition according to Claim 1 or 2,
wherein the resin is a copolymer comprising: a structural unit derived from at least one selected from the group consisting of an unsaturated carboxylic acid and an unsaturated carboxylic acid anhydride; and a structural unit derived from a monomer having a cyclic ether structure having 2 to 4 carbon atoms and an ethylenic unsaturated bond.

4. The resin composition according to any one of Claims 1 to 3,
wherein R^{x1} to R^{x4} each independently represent an aryl group having 6 to 20 carbon atoms,
R^{y1} to R^{y4} each independently represent an aryl group having 6 to 20 carbon atoms,
the ring Z¹ and the ring Z² each independently represent an aromatic hydrocarbon ring having 6 to 20 carbon atoms,
M² represents Ru, Fe, Cu, Zn, Co, Ni or Pd,
R^{1a} to R^{1d}, R^{2a} to R^{2d}, R^{3a} to R^{3d} and R^{4a} to R^{4d} each independently represent a hydrogen atom or -SR¹,
R⁴ represents a hydrogen atom or a chain hydrocarbon group having 1 to 10 carbon atoms, wherein -CH₂- contained in the chain hydrocarbon group is optionally substituted with -O-, -NR⁵- or -N⁺(R⁵R⁶)X⁻-,
M' represents Si, and
M³ represents P.

5. The resin composition according to Claim 4,
wherein R^{x1} to R^{x4} each independently represent an aryl group having 6 to 10 carbon atoms,
R^{y1} to R^{y4} each independently represent an aryl group having 6 to 10 carbon atoms,
the ring Z¹ and the ring Z² each independently represent an aromatic hydrocarbon ring having 6 to 10 carbon atoms,
M² represents Ru,
R¹ represents an aryl group having 6 to 10 carbon atoms, and
R⁴ represents a hydrogen atom or a chain hydrocarbon group having 1 to 10 carbon atoms, wherein -CH₂- contained in the chain hydrocarbon group is optionally substituted with -O- or -N⁺(R⁵R⁶)X⁻-.

6. The resin composition according to Claim 5,
wherein the coloring agent comprises a compound represented by the formula (I) or the formula (II).

7. The resin composition according to any one of Claims 1 to 3,
wherein the coloring agent comprises a compound represented by any of the following formulae, 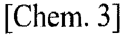 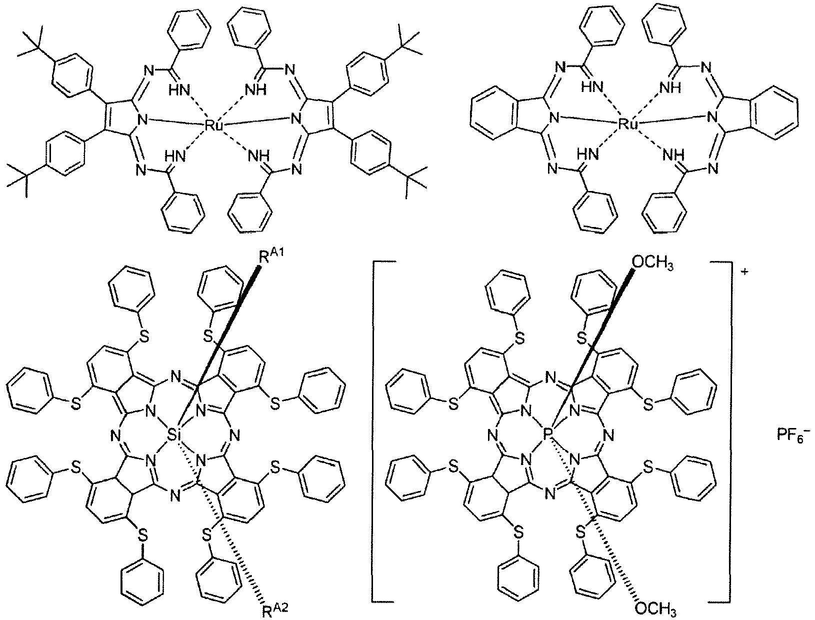
[wherein in the formulae, R^{A1} and R^{A2} represent -OCH₂CH₂OCH₂CH₂OCH₂CH₃, -OCH₂CH₂N⁺(CH₃)₃ I⁻ or a hydroxyl group.

8. An optical filter comprising a cured product of the resin composition according to any one of Claims 1 to 7.

9. A solid state image sensor comprising the optical filter according to Claim 8.
